# EUROPEAN PATENT APPLICATION

(11) **EP 4 730 958 A2**
(43) Date of publication of application: **22.04.2026**
(21) Application number: 25203634.8
(22) Date of filing: 22.09.2025
(51) Int. Cl.: H10D 84/01, B82Y 10/00, H10D 30/00, H10D 62/10, H10D 84/83, H10D 84/85, H10D 88/00, H10D 84/03

(54) **NANORIBBON-BASED DEVICE WITH SEPARATE GATE AND SOURCE OR DRAIN CONTACTS**

(30) Priority: 26.09.2024 US 202418897500
(71) Applicant: INTEL Corporation, Santa Clara, CA 95054 (US)
(72) Inventor: SHARMA, Abhishek A., Portland, 97229 (US)
(74) Representative: 2SPL Patentanwälte PartG mbB

(57) **Abstract**

Nanoribbon-based devices with separate gate, source, and/or drain contacts can enable forming multiple devices having one or more independent contacts from different nanoribbons in a stack. In one example, an integrated circuity structure includes a stack of two or more nanoribbons, a gate electrode material at least partially around portions of the two or more nanoribbons, and source or drain regions, where discontinuities (e.g., including an insulator material) may be present between portions of the gate electrode material and/or between portions of the source or drain regions. Independent contact structures may be coupled with the separate portions of the gate electrode material and/or with the separate portions of the source or drain regions.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component is becoming increasingly significant.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a perspective view of an example nanoribbon-based field-effect transistor (FET), according to some embodiments of the present disclosure.
FIGS. 2A-2G illustrate cross-sectional side views of examples of IC structures including a nanoribbon-based device with separate gate, source, and/or drain contacts, in accordance with some embodiments of the present disclosure.
FIG. 3 is a cross-sectional side view of an example IC structure that includes a nanoribbon-based device with a nanoribbon stack including a P-type nanoribbon and N-type nanoribbons and separate gate, source, and/or drain contacts, in accordance with some embodiments of the present disclosure.
FIGS. 4A-4B are top-down plan views of example IC structures that include nanoribbon-based devices with separate gate, source, and/or drain contacts, in accordance with some embodiments of the present disclosure, in accordance with some embodiments of the present disclosure.
FIGS. 5A-5D are diagrams of IC structures that include nanoribbon-based devices with separate gate, source, and/or drain contacts and examples of interconnections, in accordance with some embodiments of the present disclosure.
FIGS. 6A-6B are perspective views of an example IC structure that includes nanoribbon-based devices with separate gate, source, and/or drain contacts, in accordance with some embodiments of the present disclosure.
FIGS. 7A-7B are perspective views of another example IC structure that includes nanoribbon-based devices with separate gate, source, and/or drain contacts, in accordance with some embodiments of the present disclosure.
FIG. 8 is a circuit diagram of the example IC structures of FIGS. 6A-6B and 7A-7B, in accordance with some embodiments of the present disclosure.
FIG. 9 is a top view of a wafer and dies that may include any of the IC structures disclosed herein, in accordance with any of the embodiments disclosed herein.
FIG. 10 is a side, cross-sectional view of an IC package that may include any of the IC structures disclosed herein, in accordance with various embodiments.
FIG. 11 is a side, cross-sectional view of an IC device assembly that may include any of the IC structures disclosed herein, in accordance with any of the embodiments disclosed herein.
FIG. 12 is a block diagram of an example electrical device that may include any of the IC structures disclosed herein, in accordance with any of the embodiments disclosed herein.

### Detailed Description

Disclosed herein are integrated circuit (IC) structures including a nanoribbon-based device with separate gate, source, and/or drain contacts. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surface. A confinement surface refers to a particular orientation of the channel surface that is confined by the gate field. Non-planar transistors potentially improve performance relative to transistors having a planar architecture, such as single-gate transistors.

Nanoribbon-based transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors). As used herein, the term "nanoribbon" refers to an elongated structure of a semiconductor material having a longitudinal axis parallel to a support structure (e.g., a substrate, a die, a chip, or a wafer) over which such a structure is built. Typically, a length of a such a structure (i.e., a dimension measured along the longitudinal axis, shown in the present drawings to be along the y-axis of an example x-y-z coordinate system) is greater than each of a width (i.e., a dimension measured along the x-axis of the example coordinate system shown in the present drawings) and a thickness/height (i.e., a dimension measured along the z-axis of the example coordinate system shown in the present drawings). In some settings, the terms "nanoribbon" or "nanosheet" have been used to describe elongated semiconductor structures that have a rectangular transverse cross-section (i.e., a cross-section in a plane perpendicular to the longitudinal axis of the structure), while the term "nanowire" has been used to describe similar elongated structures but with circular transverse cross-sections. In the present disclosure, the term "nanoribbon" is used to refer to all such nanowires, nanoribbons, and nanosheets, as well as elongated semiconductor structures with a longitudinal axis parallel to the support structures and with having transverse cross-sections of any geometry (e.g., transverse cross-sections in the shape of an oval or a polygon with rounded corners). A transistor may then be described as a "nanoribbon-based transistor" if the channel of the transistor is a portion of a nanoribbon, i.e., a portion around which a gate stack of a transistor may wrap around. The semiconductor material in the portion of the nanoribbon that forms a channel of a transistor may be referred to as a "channel material," with source and drain (S/D) regions of a transistor provided on either side of the channel material.

Typically, nanoribbon-based transistor arrangements include stacks of nanoribbons, where each stack includes two or more nanoribbons stacked above one another, with a single gate stack that includes a work function material provided for an entire stack or multiple stacks. Optionally, the gate stack may also include a gate dielectric material around each nanoribbon. A device region may include many coplanar transistors formed in a stack of nanoribbons, where a nanoribbon-based transistor may include a channel region in the stack of nanoribbons (e.g., portions of the nanoribbons of the stack are channel portions) with an S/D region in the nanoribbon stack on either side of the channel region. A circuit that includes two or more nanoribbon-based transistors may be formed by interconnecting the contacts (e.g., gate contacts or S/D contacts) of the nanoribbon-based transistors with conductive interconnects in the metallization stack. Typically, NMOS nanoribbon-based transistors and PMOS nanoribbon-based transistors may be formed in different regions over a substrate (e.g., due to the granularity of the implanted regions). Thus, forming a CMOS circuit may involve coupling one or more nanoribbon-based transistors in an NMOS region (e.g., a region including a semiconductor material with N-type dopants) with one or more nanoribbon-based transistors in a PMOS region (e.g., a region including a semiconductor material with P-type dopants), resulting in a relatively large footprint.

In accordance with examples described herein, a nanoribbon-based device with separate gate, source, and/or drain contacts may enable forming a circuit including multiple stacked transistors in a single nanoribbon stack. Conductive interconnects that are coplanar with one or more nanoribbons of the stack may enable interconnecting the separate contacts of the stacked transistors with one another. In an example in which a circuit is implemented in two adjacent stacks of nanoribbons, conductive interconnects between and coplanar with the stacks may enable further interconnection of separate gate, source, and/or drain contacts of stacked transistors in the two adjacent nanoribbon stacks. In one example, a nanoribbon-based device may include separate gate contacts. In one such example, an IC structure includes a nanoribbon stack with a first nanoribbon and a second nanoribbon, a first portion of a gate electrode material at least partially around the first nanoribbon, and a second portion of the gate electrode material at least partially around the second nanoribbon, and an insulator material between the first portion and the second portion (e.g., to electrically isolate the gate around the first nanoribbon from the gate around the second nanoribbon). A first contact structure may be coupled with the first portion, and a second contact structure coupled with the second portion to enable separate control of the two stacked gate portions.

In addition to, or alternatively to, separate gate contacts, a nanoribbon-based device may include one or more separate S/D contacts. In one such example, an IC structure includes a stack with a first nanoribbon and a second nanoribbon stacked over the first nanoribbon, a first S/D region of a doped semiconductor material in the first nanoribbon in a plane that is substantially orthogonal to the first nanoribbon, a second S/D region of the doped semiconductor material in the second nanoribbon, wherein the second region is over the first region in the plane, and an insulator material between the first S/D region and the second S/D region (e.g., to electrically isolate the first S/D region from the second S/D region). A first contact structure may be coupled with the first S/D region, and a second contact structure coupled with the second S/D region to enable separate control of the two stacked S/D regions.

IC structures including nanoribbon-based devices with separate gate, source, and/or drain contacts may thus enable the fabrication of more compact circuits than possible with conventional techniques. Forming such circuits using both N-type and P-type nanoribbons (which may be stacked or adjacent to one another) may further enable compact fabrication of CMOS circuits.

IC structures as described herein, in particular IC structures including a nanoribbon-based device with separate gate, source, and/or drain contacts, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on an IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials, and configurations are set forth in order to provide a thorough understanding of the illustrative implementations. However, it will be apparent to one skilled in the art that the present disclosure may be practiced without the specific details and/or that the present disclosure may be practiced with only some of the described aspects. In other instances, well-known features are omitted or simplified in order not to obscure the illustrative implementations. The terms "substantially," "close," "approximately," "near," and "about," generally refer to being within +/- 10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/- 10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures including a nanoribbon-based device with separate gate, source, and/or drain contacts as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

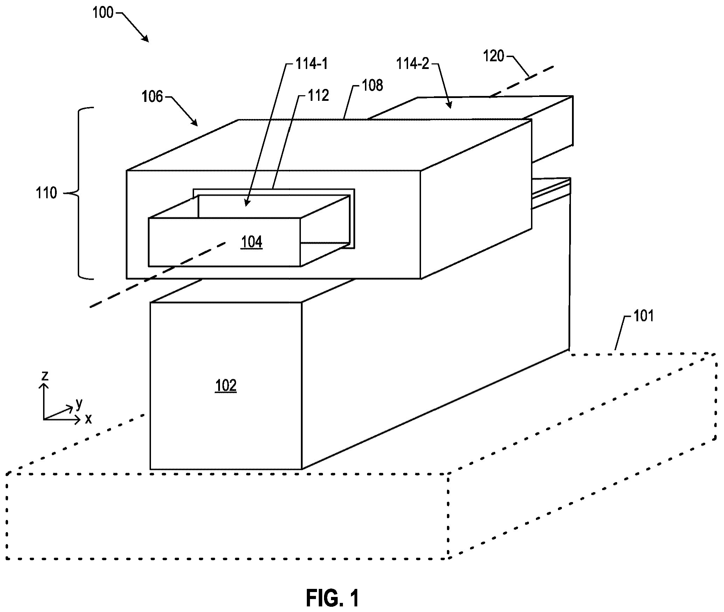

FIG. 1 provides a perspective view of an example IC structure 100 with a nanoribbon-based transistor 110 (in particular, a FET), according to some embodiments of the present disclosure. As shown in FIG. 1, the IC structure 100 includes a semiconductor material formed as a nanoribbon 104 extending substantially parallel to a support 101. The transistor 110 may be formed on the basis of the nanoribbon 104 by having a gate stack 106 wrap around at least a portion of the nanoribbon referred to as a "channel portion" and by having source and drain regions, shown in FIG. 1 as a first S/D region 114-1 and a second S/D region 114-2, on either side of the gate stack 106. One of the S/D regions 114-1, 114-2 is a source region and the other one is a drain region. However, because, as is common in the field of FETs, designations of source and drain are often interchangeable, they are simply referred to herein as a first S/D region 114-1 and a second S/D region 114-2.

The nanoribbon 104 may take the form of a nanowire or nanoribbon, for example. In some embodiments, an area of a transversal cross-section of the nanoribbon 104 (i.e., an area in the x-z plane of the example coordinate system x-y-z shown in FIG. 1, perpendicular to a longitudinal axis 120 of the nanoribbon 104) may be between about 25 and 10000 square nanometers, including all values and ranges therein (e.g., between about 25 and 1000 square nanometers, or between about 25 and 500 square nanometers). In some embodiments, a width of the nanoribbon 104 (i.e., a dimension measured in a plane parallel to the support 101 and in a direction perpendicular to the longitudinal axis 120 of the nanoribbon 104, e.g., along the y-axis of the example coordinate system shown in FIG. 1) may be at least about 3 times larger than a height of the nanoribbon 104 (i.e., a dimension measured in a plane perpendicular to the support 101, e.g., along the z-axis of the example coordinate system shown in FIG. 1), including all values and ranges therein, e.g., at least about 4 times larger, or at least about 5 times larger. Although the nanoribbon 104 illustrated in FIG. 1 is shown as having a rectangular cross-section, the nanoribbon 104 may instead have a cross-section that is rounded at corners or otherwise irregularly shaped, and the gate stack 106 may conform to the shape of the nanoribbon 104. The term "face" of a nanoribbon may refer to the side of the nanoribbon 104 that is larger than the side perpendicular to it (when measured in a plane substantially perpendicular to the longitudinal axis 120 of the nanoribbon 104), the latter side being referred to as a "sidewall" of a nanoribbon.

In various embodiments, the semiconductor material of the nanoribbon 104 may be composed of semiconductor material systems including, for example, N-type or P-type materials systems. In some embodiments, the nanoribbon 104 may include a high mobility oxide semiconductor material, such as tin oxide, antimony oxide, indium oxide, indium tin oxide, titanium oxide, zinc oxide, indium zinc oxide, gallium oxide, titanium oxynitride, ruthenium oxide, or tungsten oxide. In some embodiments, the nanoribbon 104 may include a combination of semiconductor materials. In some embodiments, the nanoribbon 104 may include a monocrystalline semiconductor, such as silicon (Si) or germanium (Ge). In some embodiments, the nanoribbon 104 may include a compound semiconductor with a first sub-lattice of at least one element from group III of the periodic table (e.g., Al, Ga, In), and a second sub-lattice of at least one element of group V of the periodic table (e.g., P, As, Sb).

For some example N-type transistor embodiments (i.e., for the embodiments where the transistor 110 is an N-type metal-oxide-semiconductor (NMOS) transistor), the channel material of the nanoribbon 104 may include a III-V material having a relatively high electron mobility, such as, but not limited to InGaAs, InP, InSb, and InAs. For some such embodiments, the channel material of the nanoribbon 104 may be a ternary III-V alloy, such as InGaAs, GaAsSb, InAsP, or InPSb. For some InₓGa₁₋ₓAs fin embodiments, In content (x) may be between 0.6 and 0.9, and may advantageously be at least 0.7 (e.g., In_{0.7}Ga_{0.3}As). For some example P-type transistor embodiments (i.e., for the embodiments where the transistor 110 is a P-type metal-oxide-semiconductor (PMOS) transistor), the channel material of the nanoribbon 104 may advantageously be a group IV material having a high hole mobility, such as, but not limited to Ge or a Ge-rich SiGe alloy. For some example embodiments, the channel material of the nanoribbon 104 may have a Ge content between 0.6 and 0.9, and advantageously may be at least 0.7.

In some embodiments, the channel material of the nanoribbon 104 may be a thin-film material, such as a high mobility oxide semiconductor material, such as tin oxide, antimony oxide, indium oxide, indium tin oxide, titanium oxide, zinc oxide, indium zinc oxide, indium gallium zinc oxide (IGZO), gallium oxide, titanium oxynitride, ruthenium oxide, or tungsten oxide. In general, if the transistor formed in the nanoribbon is a thin-film transistor (TFT), the channel material of the nanoribbon 104 may include one or more of tin oxide, cobalt oxide, copper oxide, antimony oxide, ruthenium oxide, tungsten oxide, zinc oxide, gallium oxide, titanium oxide, indium oxide, titanium oxynitride, indium tin oxide, indium zinc oxide, nickel oxide, niobium oxide, copper peroxide, IGZO, indium telluride, molybdenite, molybdenum diselenide, tungsten diselenide, tungsten disulfide, N- or P-type amorphous or polycrystalline silicon, germanium, indium gallium arsenide, silicon germanium, gallium nitride, aluminum gallium nitride, indium phosphite, and black phosphorus, each of which may possibly be doped with one or more of gallium, indium, aluminum, fluorine, boron, phosphorus, arsenic, nitrogen, tantalum, tungsten, and magnesium, etc. In some embodiments, the channel material of the nanoribbon 104 may have a thickness between about 5 and 75 nanometers, including all values and ranges therein. In some embodiments, a thin-film channel material may be deposited at relatively low temperatures, which allows depositing the channel material within the thermal budgets imposed on back end fabrication to avoid damaging other components, e.g., front end components such as the logic devices.

A gate stack 106 including a gate electrode material 108 and, optionally, a gate dielectric material 112, may wrap entirely or almost entirely around a portion of the nanoribbon 104 as shown in FIG. 1, with the active region (channel region) of the channel material of the transistor 110 corresponding to the portion of the nanoribbon 104 wrapped by the gate stack 106. As shown in FIG. 1, the gate dielectric material 112 may wrap around a transversal portion of the nanoribbon 104 and the gate electrode material 108 may wrap around the gate dielectric material 112.

The gate electrode material 108 may include at least one P-type work function metal or N-type work function metal, depending on whether the transistor 110 is a PMOS transistor or an NMOS transistor (P-type work function metal used as the gate electrode material 108 when the transistor 110 is a PMOS transistor and N-type work function metal used as the gate electrode material 108 when the transistor 110 is an NMOS transistor). For a PMOS transistor, metals that may be used for the gate electrode material 108 may include, but are not limited to, ruthenium, palladium, platinum, cobalt, nickel, and conductive metal oxides (e.g., ruthenium oxide). For an NMOS transistor, metals that may be used for the gate electrode material 108 include, but are not limited to, hafnium, zirconium, titanium, tantalum, aluminum, alloys of these metals, and carbides of these metals (e.g., hafnium carbide, zirconium carbide, titanium carbide, tantalum carbide, and aluminum carbide). In some embodiments, the gate electrode material 108 may include a stack of two or more metal layers, where one or more metal layers are work function metal layers and at least one metal layer is a fill metal layer. Further layers may be included next to the gate electrode material 108 for other purposes, such as to act as a diffusion barrier layer or/and an adhesion layer.

In some embodiments, the gate dielectric material 112 may include one or more high-k dielectrics including any of the materials discussed herein with reference to the insulator material that may surround portions of the transistor 110. In some embodiments, an annealing process may be carried out on the gate dielectric material 112 during fabrication of the transistor 110 to improve the quality of the gate dielectric material 112. The gate dielectric material 112 may have a thickness that may, in some embodiments, be between about 0.5 nanometers and 3 nanometers, including all values and ranges therein (e.g., between about 1 and 3 nanometers, or between about 1 and 2 nanometers). In some embodiments, the gate stack 106 may be surrounded by a gate spacer, not shown in FIG. 1. Such a gate spacer would be configured to provide separation between the gate stack 106 and source/drain contacts of the transistor 110 and could be made of a low-k dielectric material, some examples of which have been provided above. A gate spacer may include pores or air gaps to further reduce its dielectric constant.

Turning to the S/D regions 114-1, 114-2 of the transistor 110, in some embodiments, the S/D regions may be highly doped, e.g., with dopant concentrations of about 10²¹ cm⁻³, in order to advantageously form Ohmic contacts with the respective S/D electrodes, although these regions may also have lower dopant concentrations and may form Schottky contacts in some implementations. Irrespective of the exact doping levels, the S/D regions of a transistor are the regions having dopant concentration higher than in other regions, e.g., higher than a dopant concentration in the transistor channel (i.e., in a channel material extending between the first S/D region 114-1 and the second S/D region 114-2), and, therefore, may be referred to as "highly doped" (HD) regions. Even with doped to realize threshold voltage tuning as described herein, the channel portions of transistors typically include semiconductor materials with doping concentrations significantly smaller than those of the S/D regions 114-1, 114-2.

The S/D regions 114-1, 114-2 of the transistor 110 may generally be formed using either an implantation/diffusion process or an etching/deposition process. In the former process, dopants such as boron, aluminum, antimony, phosphorous, or arsenic may be ion-implanted into the nanoribbon 104 to form the source and drain regions. An annealing process that activates the dopants and causes them to diffuse further into the nanoribbon 104 may follow the ion implantation process. In the latter process, portions of the nanoribbon 104 may first be etched to form recesses at the locations of the future S/D regions 114-1, 114-2. An epitaxial deposition process may then be carried out to fill the recesses with material that is used to fabricate the S/D regions 114-1, 114-2. In some implementations, the S/D regions 114-1, 114-2 may be fabricated using a silicon alloy such as silicon germanium or silicon carbide. In some implementations, the epitaxially deposited silicon alloy may be doped in situ with dopants such as boron, arsenic, or phosphorous. In further embodiments, the S/D regions 114-1, 114-2 may be formed using one or more alternate semiconductor materials such as germanium or a group III-V material or alloy. And in further embodiments, one or more layers of metal and/or metal alloys may be used to form the S/D regions 114-1, 114-2. In some embodiments, a distance between the first and second S/D regions 114-1, 114-2 (i.e., a dimension measured along the longitudinal axis 120 of the nanoribbon 104) may be between about 5 and 40 nanometers, including all values and ranges therein (e.g., between about 22 and 35 nanometers, or between about 20 and 30 nanometers).

The IC structure 100 shown in FIG. 1, as well as IC structures shown in other drawings of the present disclosure, is intended to show relative arrangements of some of the components therein, and the IC structure 100, or portions thereof, may include other components that are not illustrated (e.g., electrical contacts to the S/D regions 114-1, 114-2 of the transistor 110, additional layers such as a spacer layer around the gate electrode of the transistor 110, etc.). For example, although not specifically illustrated in FIG. 1, a dielectric spacer may be provided between a first S/D electrode (which may also be referred to as a "first S/D contact") coupled to a first S/D region 114-1 of the transistor 110 and the gate stack 106 as well as between a second S/D electrode (which may also be referred to as a "second S/D contact") coupled to a second S/D region 114-2 of the transistor 110 and the gate stack 106 in order to provide electrical isolation between the source, gate, and drain electrodes. In another example, although not specifically illustrated in FIG. 1, at least portions of the transistor 110 may be surrounded in an insulator material, such as any suitable interlayer dielectric (ILD) material. In some embodiments, such an insulator material may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material surrounding portions of the transistor 110 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

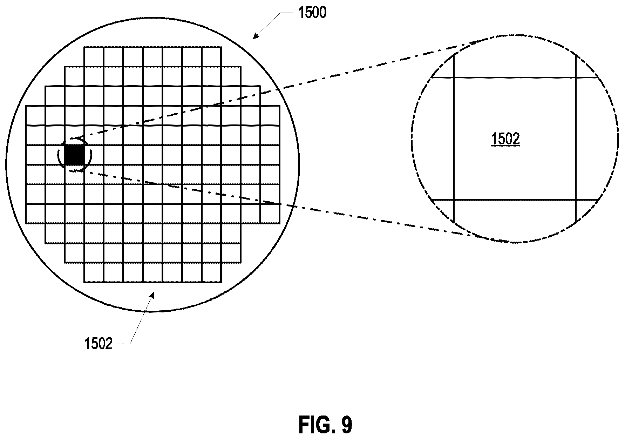

Implementations of the present disclosure may be formed or carried out on any suitable support structure, such as a substrate, a die, a wafer, or a chip. The support structure may, e.g., be the wafer 1500 of FIG. 9, discussed below, and may be, or be included in, a die, e.g., the singulated die 1502 of FIG. 9, discussed below. The support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the support structure may be formed are described here, any material that may serve as a foundation upon which an IC structure with nanoribbon-based transistors and an etch-stop layer below the nanoribbons as described herein may be built falls within the spirit and scope of the present disclosure.

As further shown in FIG. 1, the IC structure 100 includes a replacement structure 102 between the transistor 110 and the support 101. The replacement structure 102 may be what was originally a subfin made of the semiconductor material of the nanoribbon 104 and, optionally, of an upper portion of the support 101. An opening in the IC structure 100 formed by the removal of the subfin may subsequently be filled with any suitable material, e.g., an insulator material, thus forming the replacement structure 102. The support 101 is shown in FIG. 1 with a dotted outline to illustrate that, in one scenario, it may be a support structure as described above over which the nanoribbon 104 may be originally provided. In another scenario, the dotted outline of the support 101 is used to represent that the support 101 may be any other structure to which the transistor 110 and the replacement structure 102 may be attached after the original support structure is removed and the subfin is replaced with the replacement structure 102. For example, in some embodiments according to this scenario, the support 101 may be a carrier substrate, a package substrate, an interposer, or another die. In other examples, the subfin of the semiconductor material of the nanoribbon 104 may not be removed, and the IC structure may lack a replacement structure 102.

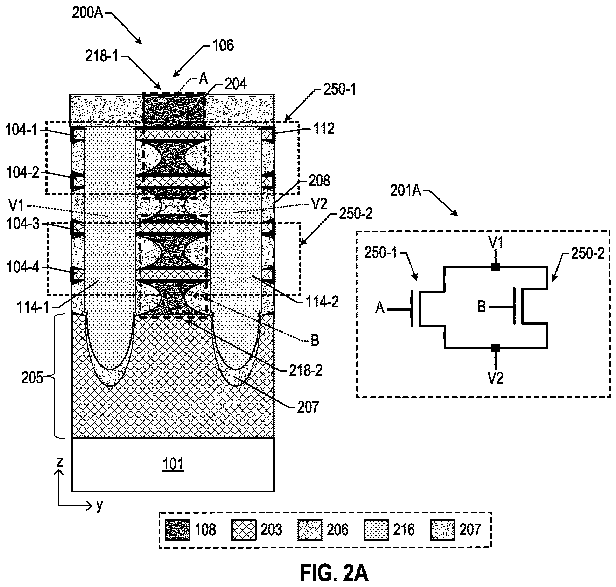

Although only one nanoribbon 104 is shown in FIG. 1, the IC structure 100 may include a plurality of such nanoribbons 104 stacked above one another, e.g., as is shown in FIGS. 2A-2G showing IC structures which may be one example of the IC structure 100.

FIGS. 2A-2G illustrate cross-sectional side views of examples of IC structures including a nanoribbon-based device with separate gate, source, and/or drain contacts and corresponding circuit diagrams, in accordance with some embodiments of the present disclosure. A number of elements referred to in the description of FIGS. 2A-2G, 3, 4A-4B, and 5A-5D, with reference numerals are illustrated in these drawings with different patterns, with a legend showing the correspondence between the reference numerals and patterns being provided at the bottom of each drawing page containing FIGS. 2A-2G, 3, 4A-4B, and 5A-5D. For example, the legend illustrates that FIGS. 2A use different patterns to show a semiconductor material 203 and a gate electrode material 108, and so on.

Referring first to FIG. 2A, the IC structure 200A includes a stack 204 of nanoribbons 104, 104-1, 104-2, 104-3, and 104-4 (which may be referred to herein as nanoribbons 104). While four nanoribbons 104 are shown to be included in the stack 204, in other embodiments, fewer nanoribbons 104 or more nanoribbons 104 may be included. FIG. 2A illustrates a semiconductor material 203 as the material of the nanoribbons 104, further illustrating a subfin 205 of the semiconductor material 203 below the nanoribbon stack 204, although in some embodiments, the nanoribbons 104 and at least a portion of the subfin 205 may include semiconductor materials of different material compositions. As mentioned briefly above, in some examples, some or all of the semiconductor material 203 of the subfin 205 may be replaced with another material (such as an insulator material). As shown in FIG. 2A, a gate stack 106 having a gate insulator material 112 and a gate electrode material 108 may wrap around channel portions of the nanoribbons 104. Unlike in existing nanoribbon-based devices, in which a continuous portion of the gate electrode material 108 may wrap around all the nanoribbons 104 in the stack 204, FIG. 2A illustrates an example in which there are two separate portions 218-1, 218-2 of the gate electrode material 108 separated by an insulator material 206. For example, the portion 218-1 of the gate electrode material 108 is at least partially around the nanoribbons 104-1 and 104-2, and the portion 218-2 of the gate electrode material 108 is at least partially around the nanoribbons 104-3 and 104-4. Separate gate contact structures (not shown in FIG. 2A), may couple with the portions 218-1 and 218-2. As is discussed in more detail below, gate contact structures may be frontside contacts (e.g., contact structures that couple with the portions 218-1, 218-2 from a front side of the IC structure) or backside contacts (e.g., contact structures that couple with the portions 218-1, 218-2 from a back side of the IC structure).

FIG. 2A further illustrates a first S/D region 114-1 and a second S/D region 114-2 extending through the nanoribbon stack 204, where the S/D regions 114-1 and 114-2 include a doped semiconductor material 216. The S/D regions 114-1 and 114-2 are electrically insulated/separated from the gate electrode material 108 and from the semiconductor material 203 of the subfin 205 by an insulator material 207. The insulator material 207 may be the same as or different from the insulator material 206. In some embodiments, the insulator material 207 may form so-called "dimples" 208 in areas where the insulator material 207 separates the S/D regions 114-1, 114-2 from the gate electrode material 108. The insulator materials 206 and 207 may include any of the insulator materials described herein, e.g., any of the ILD materials described above. The IC structure may include S/D contact structures (not shown in FIG. 2A) coupled with the S/D regions 114-1, 114-2, where the gate contact structures may be front side contacts or back side contacts.

The IC structure 200A thus includes two separate portions 218-1, 218-2 of gate electrode material 108, where a first portion 218-1 is at least partially around the nanoribbons 104-1, 104-2, and where a second portion 218-2 is at least partially around the nanoribbons 104-3, 104-4. The first and second portions 218-1, 218-2 are therefore vertically aligned with one another (e.g., stacked over one another). A first S/D region 114-1 and a second S/D region 114-2 are on either side of both portions 218-1 and 218-2 of the gate electrode material 108. In the example illustrated in FIG. 2A, the IC structure includes two transistors 250-1 and 250-2, where a first transistor 250-1 has a first channel region in portions of the nanoribbons 104-1 and 104-2, and a second transistor 250-2 has a second channel region in portions of the nanoribbons 104-3 and 104-4. The portion 218-1 of the gate electrode material 108 is around the first channel region of the first transistor 250-1, and the portion 218-2 of the gate electrode material 108 is around the second channel region of the second transistor 250-2. The first S/D region 114-1 is either a source or drain region (e.g., a shared source region) for both the transistors 250-1 and 250-2, and the second S/D region 114-2 is either a source or drain region (e.g., a shared drain region) for both of the transistors 250-1 and 250-2. In the example illustrated in FIG. 2A, a voltage 'A' is applied to the gate of the first transistor 250-1 (e.g., via a first gate contact structure and the portion 218-1), and a voltage 'B' is applied to the gate of the second transistor 250-2 (e.g., via a second gate contact structure and the portion 218-2). Because the source and drain regions of the transistors 250-1 and 250-2 are shared, the source regions of the transistors 250-1 and 250-2 are at the same voltage (e.g., V1) and the drain regions of the transistors 250-1 and 250-2 are at the same voltage (e.g., V2).

FIG. 2A illustrates an example circuit diagram 201A that may be formed with the IC structure 200A. As can be seen in FIG. 2A, a different input may be applied to the gates of the transistors 250-1 and 250-2 to independently control whether the transistors 250-1 and 250-2 are on or off (e.g., the input voltage A is applied to the gate of the transistor 250-1 and the input voltage B is applied to the gate of the transistor 250-2). In the illustrated example, the source terminals of the transistors 250-1 and 250-2 are tied together (e.g., tied to the same input voltage V1), and the drain terminals of the transistors 250-1 and 250-2 are tied together (e.g., tied to the same output voltage V2). Thus, in one example, the IC structure 200A may include two stacked nanoribbon-based transistors 250-1 and 250-2 with independent gates and shared source and drain terminals.

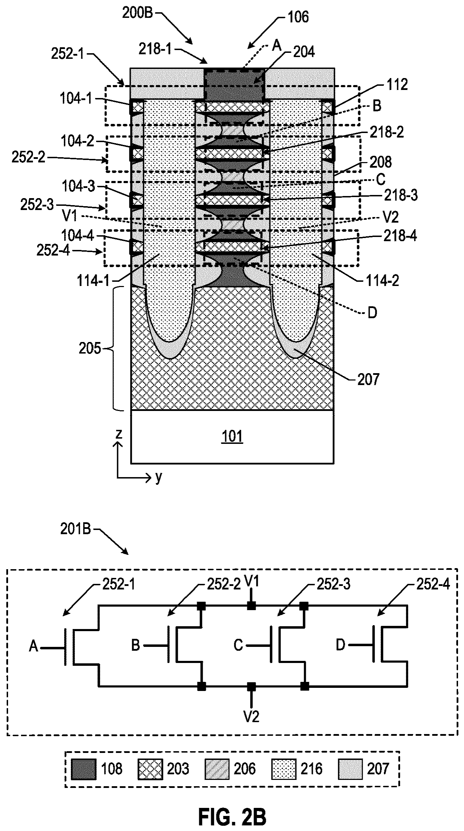

FIG. 2B illustrates another example of an IC structure 200B including a nanoribbon-based device with separate gate, source, and/or drain contacts and a corresponding circuit diagram 201B. The IC structure 200B of FIG. 2B is similar to the IC structure 200A of FIG. 2A in that there are separate portions 218-1, 218-2, 218-3, and 218-4 of the gate electrode material 108 around different nanoribbons 104. However, unlike the IC structure 200A of FIG. 2A in which each of the portions 218-1 and 218-2 at least partially surrounded portions of two nanoribbons, in FIG. 2B, the separate portions 218-1, 218-2, 218-3, and 218-4 of the gate electrode material 108 partially surround a single nanoribbon. For example, as can be seen in FIG. 2B, adjacent portions of the gate electrode material 108 are separated by the insulator material 206. Therefore, in the example illustrated in FIG. 2B, the IC structure includes four separate portions 218-1, 218-2, 218-3, and 218-4 of gate electrode material 108, which may be coupled with four separate gate contact structures.

Thus, in the example illustrated in FIG. 2B, the IC structure 200B includes four transistors 252-1, 252-2, 252-3, and 252-4, where a first transistor 252-1 has a first channel region in a portion of the nanoribbon 104-1, a second transistor 252-2 has a second channel region in a portion of the nanoribbon 104-2, a third transistor 252-3 has a third channel region in a portion of the nanoribbon 104-3, and a fourth transistor 252-4 has a fourth channel region in a portion of the nanoribbon 104-4. In the example illustrated in FIG. 2B, the first S/D region 114-1 is either a source or drain region (e.g., a shared source region) for all four of the transistors 252-1, 252-2, 252-3, and 252-4 and the second S/D region 114-2 is either a source or drain region (e.g., a shared drain region) for all four of the transistors 252-1 252-2, 252-3, and 252-4. In the example illustrated in FIG. 2B, a voltage 'A' is applied to the gate of the first transistor 252-1 (e.g., via a first gate contact structure and the portion 218-1), a voltage 'B' is applied to the gate of the second transistor 252-2 (e.g., via a second gate contact structure and the portion 218-2), a voltage 'C' is applied to the gate of the third transistor 252-3 (e.g., via a third gate contact structure and the portion 218-3), and a voltage 'D' is applied to the gate of the fourth transistor 252-4 (e.g., via a fourth gate contact structure and the portion 218-4). Because the source and drain regions of the transistors 252-1, 252-2, 252-3, and 252-4 are shared, the source regions of the transistors 252-1, 252-2, 252-3, and 252-4 are at the same voltage (e.g., V1) and the drain regions of the transistors 252-1, 252-2, 252-3, and 252-4 are at the same voltage (e.g., V2).

FIG. 2B illustrates an example circuit diagram 201B that may be formed with the IC structure 200B. As can be seen in FIG. 2B, different inputs may be applied to the gates of the transistors 252-1, 252-2, 252-3, and 252-4 to independently control whether the transistors 252-1, 252-2, 252-3, and 252-4 are on or off (e.g., the input voltage A is applied to the gate of the transistor 252-1, the input voltage B is applied to the gate of the transistor 252-2, the input voltage C is applied to the gate of the transistor 252-3, and the input voltage D is applied to the gate of the transistor 252-4). In the illustrated example, the source terminals of the transistors 252-1, 252-2, 252-3, and 252-4 are tied together (e.g., tied to the same input voltage V1), and the drain terminals of the transistors 252-1, 252-2, 252-3, and 252-4 are tied together (e.g., tied to the same output voltage V2). Thus, in one example, the IC structure 200B may include four stacked nanoribbon-based transistors 252-1, 252-2, 252-3, and 252-4 with independent gates and shared source and drain terminals.

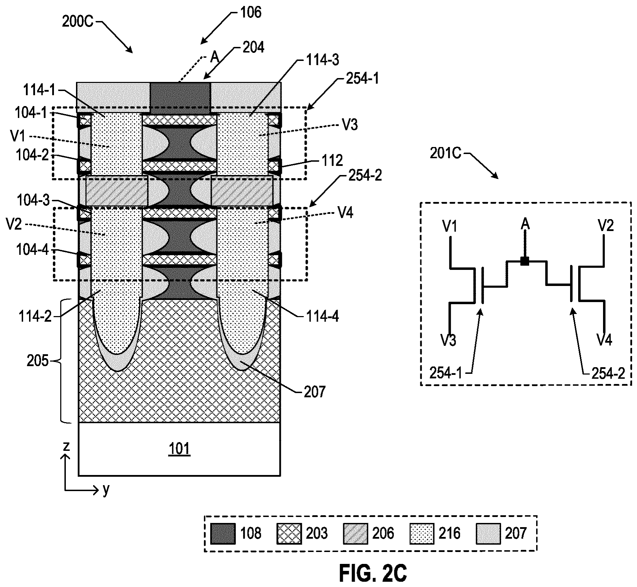

FIG. 2C illustrates another example of an IC structure 200C including a nanoribbon-based device with separate gate, source, and/or drain contacts and a corresponding circuit diagram 201C. Unlike in FIGS. 2A and 2B in which the IC structures 200A and 200B include separate portions of the gate electrode material 108, the IC structure 200C includes separate S/D regions coupled with different nanoribbons in the stack 204. For example, as can be seen in FIG. 2C, the IC structure 200C includes a first region (e.g., the region 114-1) of a doped semiconductor material in the stack 204, coplanar with the first nanoribbon 104-1, and coupled with the first nanoribbon 104-1, and a second region (e.g., the region 114-2) of the doped semiconductor material in the stack 204, coplanar with another nanoribbon 104-3 in the stack 204, and coupled with the nanoribbon 104-3, and an insulator material 206 between the first region 114-1 and the second region 114-2. The regions 114-1 and 114-2 are vertically aligned in the stack 204 (e.g., the region 114-1 is over the region 114-2). The IC structure 200C further includes a third region 114-3 of the doped semiconductor material in the stack 204, coplanar with the first nanoribbon 104-1, and coupled with the first nanoribbon 104-1 (e.g., where one of the first region 114-1 and the third region 114-3 is a source region and the other of the first region 114-1 and the third region 114-3 is a drain region of a first transistor 254-1), and a fourth region 114-4 of the doped semiconductor material in the stack 204, coplanar with the nanoribbon 104-3 and the region 114-2, and coupled with the nanoribbon 104-3 (e.g., where one of the second region 114-2 and the fourth region 114-4 is a source region and the other of the second region 114-2 and the fourth region 114-4 is a drain region of a second transistor 254-2). The IC structure 200C further includes the insulator material 206 between the third region 114-3 and the fourth region 114-4. In the example illustrated in FIG. 2C, two nanoribbons are coupled with the same S/D regions (e.g., both the nanoribbons 104-1 and 104-2 are coupled with and coplanar with the S/D regions 114-1 and 114-3, and both the nanoribbons 104-3 and 104-4 are coupled with and coplanar with the S/D regions 114-2 and 114-4). In other examples, one or more S/D regions may be coupled with a single nanoribbon or more than two nanoribbons.

The gate electrode material 108 is at least partially wrapping around the nanoribbons 104-1, 104-2, 104-3 and 104-4. In the example illustrated in FIG. 2C, there is a continuous portion of the gate electrode material 108 between the nanoribbon 104-1 and the nanoribbon 104-4. Thus, in the example illustrated in FIG. 2C, the gate electrode material is shared (e.g., not separated into different portions) by the nanoribbons 104-1, 104-2, 104-3, and 104-4. The continuous portion of the gate electrode material 108 is further coupled with the nanoribbons 104-2, 104-3, and 104-4 (e.g., there is a continuous portion of the gate electrode material 108 at least partially around all the nanoribbons 104 of the stack 204).

Thus, in the example illustrated in FIG. 2C, the IC structure 200C includes two transistors 254-1 and 254-2, where a first transistor 254-1 has a first channel region in portions of the nanoribbons 104-1 and 104-2, and a second transistor 254-2 has a second channel region in portions of the nanoribbons 104-3 and 104-4. In the example illustrated in FIG. 2C, the first S/D region 114-1 and the third S/D region 114-3 are source or drain regions for the transistor 254-1, and the second S/D region 114-2 and the fourth S/D region 114-4 are source or drain regions for the transistor 252-2. In the example illustrated in FIG. 2C, a voltage 'A' is applied to the gate of both the first transistor 254-1 and the second transistor 254-2 (e.g., via a gate contact structure). Because the source and drain regions of the transistors 254-1 and 254-2 are electrically isolated from one another and independent, the regions 114-1, 114-2, 114-3, and 114-4 may be at different voltages. For example, the S/D region 114-1 may be at the voltage V1, the S/D region 114-2 may be at the voltage V2, the S/D region 114-3 may be at the voltage V3, and the S/D region 114-4 may be at the voltage V4.

FIG. 2C illustrates an example circuit diagram 201C that may be formed with the IC structure 200C. As can be seen in FIG. 2C, an input 'A' is applied to the gates of the transistors 254-1 and 254-2. The source and drain terminals of the transistor 254-1 may be at voltages V1 and V3, and the source and drain terminals of the transistor 254-2 may be at the voltages V2 and V4. Thus, in one example, the IC structure 200C may include two stacked nanoribbon-based transistors 254-1 and 254-2 with a shared gate and independent source and drain terminals.

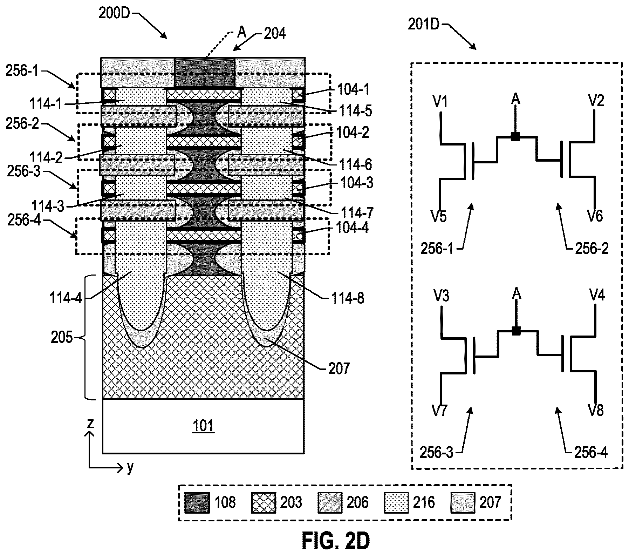

FIG. 2D illustrates another example of an IC structure 200D including a nanoribbon-based device with separate gate, source, and/or drain contacts and a corresponding circuit diagram 201D. The IC structure 200C of FIG. 2D is similar to the IC structure 200C of FIG. 2C in that the IC structure 200C includes separate regions of a doped semiconductor material coupled with different nanoribbons in a stack. However, unlike in FIG. 2C where each S/D region is coupled with two nanoribbons, the IC structure 200D of FIG. 2D includes a separate source and drain region coupled with each nanoribbon in the stack 204. For example, as can be seen in FIG. 2D, the IC structure 200D includes a first region (e.g., the region 114-1) of a doped semiconductor material in the stack 204, coplanar with and coupled with the first nanoribbon 104-1, a second region (e.g., the region 114-2) of the doped semiconductor material in the stack 204, coplanar with and coupled with the second nanoribbon 104-2, a third region (e.g., the region 114-3) of the doped semiconductor material in the stack 204, coplanar with and coupled with the third nanoribbon 104-3, a fourth region (e.g., the region 114-4) of the doped semiconductor material in the stack 204, coplanar with and coupled with the fourth nanoribbon 104-4, a fifth region (e.g., the region 114-5) of the doped semiconductor material in the stack 204, coplanar with the first region 114-1 and coplanar with and coupled with the first nanoribbon 104-1, a sixth region (e.g., the region 114-6) of the doped semiconductor material in the stack 204, coplanar with the second region 114-2 and coplanar with and coupled with the second nanoribbon 104-2, a seventh region (e.g., the region 114-7) of the doped semiconductor material in the stack 204, coplanar with the third region 114-3 and coplanar with and coupled with the third nanoribbon 104-3, and an eighth region (e.g., the region 114-8) of the doped semiconductor material in the stack 204, coplanar with the fourth region 114-4 and coplanar with and coupled with the fourth nanoribbon 104-4.

The regions 114-1, 114-2, 114-3, and 114-4 are vertically aligned (e.g., over one another in a plane). Similarly, the regions 114-5, 114-6, 114-7, and 114-8 are vertically aligned. An insulator material 206 is present between the first region 114-1 and the second region 114-2, between the second region 114-2 and the third region 114-3, between the fifth region 114-5 and the sixth region 114-6, between the sixth region 114-6 and the seventh region 114-7, and between the seventh region 114-7 and the eighth region 114-8. The insulator material 206 between vertically aligned adjacent S/D regions electrically isolates the adjacent S/D regions from one another. One of the first region 114-1 and the fifth region 114-5 is a source region and the other of the first region 114-1 and the fifth region 114-5 is a drain region of a first transistor 256-1. One of the second region 114-2 and the sixth region 114-6 is a source region and the other of the second region 114-2 and the sixth region 114-6 is a drain region of a second transistor 256-2. One of the third region 114-3 and the seventh region 114-7 is a source region and the other of the third region 114-3 and the seventh region 114-7 is a drain region of a third transistor 256-3. One of the fourth region 114-4 and the eighth region 114-8 is a source region and the other of the fourth region 114-4 and the eighth region 114-8 is a drain region of a fourth transistor 256-4.

The gate electrode material 108 is at least partially wrapping around the nanoribbons 104-1, 104-2, 104-3 and 104-4. In the example illustrated in FIG. 2D, there is a continuous portion of the gate electrode material 108 between the nanoribbon 104-1 and the nanoribbon 104-4. Thus, in the example illustrated in FIG. 2D, the gate electrode material is shared (e.g., not separated into different portions) by the nanoribbons 104-1, 104-2, 104-3, and 104-4. The continuous portion of the gate electrode material 108 is further coupled with the nanoribbons 104-2, 104-3, and 104-4 (e.g., there is a continuous portion of the gate electrode material 108 at least partially around all the nanoribbons 104 of the stack 204).

Thus, in the example illustrated in FIG. 2D, the IC structure 200D includes four transistors 256-1, 256-2, 256-3, and 256-4, where a first transistor 256-1 has a first channel region in a portion of the nanoribbon 104-1, a second transistor 256-2 has a second channel region in a portion of the nanoribbon 104-2, a third transistor 256-3 has a third channel region in a portion of the nanoribbon 104-3, and a fourth transistor 256-4 has a fourth channel region in a portion of the nanoribbon 104-4. In the example illustrated in FIG. 2D, the first S/D region 114-1 and the fifth S/D region 114-5 are source or drain regions for the transistor 256-1, and so forth, as indicated above in the previous paragraph. In the example illustrated in FIG. 2D, a voltage 'A' is applied to the gate of the transistors 256-1, 256-2, 256-3, and 256-4 (e.g., via a gate contact structure). Because the source and drain regions of the transistors 256-1, 256-2, 256-3, and 256-4 are electrically isolated from one another and independent, the regions 114-1, 114-2, 114-3, 114-4, 114-5, 114-6, 114-7, and 114-8 may be at different voltages. In order to not obscure the details of the drawing, voltages associated with the regions 114-1, 114-2, 114-3, 114-4, 114-5, 114-6, 114-7, and 114-8 are labeled on the circuit diagram 201D, but not on the IC structure 200D.

FIG. 2D illustrates an example circuit diagram 201D that may be formed with the IC structure 200D. As can be seen in FIG. 2D, an input 'A' is applied to the gates of the transistors 256-1, 256-2, 256-3, and 256-4. The source and drain terminals of the transistor 256-1 may be at voltages V1 and V5, the source and drain terminals of the transistor 256-2 may be at voltages V2 and V6, the source and drain terminals of the transistor 256-3 may be at voltages V3 and V7, and the source and drain terminals of the transistor 256-4 may be at the voltages V4 and V8. Thus, in one example, the IC structure 200D may include four stacked nanoribbon-based transistors 256-1, 256-2, 256-3, and 256-4 with a shared gate and independent source and drain terminals.

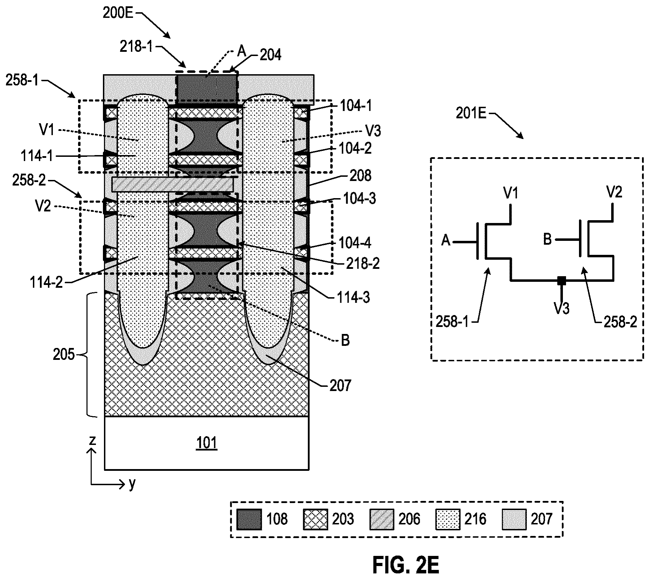

FIG. 2E illustrates another example of an IC structure 200E including a nanoribbon-based device with separate gate, source, and/or drain contacts and a corresponding circuit diagram 201E. The example illustrated in FIG. 2E includes a discontinuity in the gate electrode material 108 and a discontinuity in the doped semiconductor material to enable an IC structure 200E with two stacked transistors with separate portions of gate electrode material, where one of the S/D regions of the two transistors is shared and one of the S/D regions of the two transistors is independent. For example, as can be seen in FIG. 2E, the IC structure 200E includes a first region (e.g., the region 114-1) of a doped semiconductor material in the stack 204, coplanar with the first nanoribbon 104-1 and the second nanoribbon 104-2, and coupled with the first nanoribbon 104-1 and second nanoribbon 104-2, a second region (e.g., the region 114-2) of the doped semiconductor material in the stack 204, coplanar with the third nanoribbon 104-3 and the fourth nanoribbon 104-4 in the stack 204, and coupled with the nanoribbons 104-3 and 104-4, and a third region (e.g., the region 114-3) of the doped semiconductor material in the stack 204, where the third region is coplanar with and coupled with the first nanoribbon 104-1, second nanoribbon 104-2, third nanoribbon 104-3, and fourth nanoribbon 104-4. The third region 114-3 is also coplanar with both the first region 114-1 and the second region 114-2. An insulator material 206 is present between the first region 114-1 and the second region 114-2. The regions 114-1 and 114-2 are vertically aligned in the stack 204 (e.g., the region 114-1 is over the region 114-2). One of the first region 114-1 and the third region 114-3 is a source region and the other of the first region 114-1 and the third region 114-3 is a drain region of a first transistor 258-1. One of the second region 114-2 and the third region 114-3 is a source region and the other of the second region 114-2 and the third region 114-3 is a drain region of a second transistor 258-2. In the example illustrated in FIG. 2E, two nanoribbons are coupled with the same S/D regions (e.g., both the nanoribbons 104-1 and 104-2 are coupled with and coplanar with the S/D regions 114-1 and 114-3, and both the nanoribbons 104-3 and 104-4 are coupled with and coplanar with the S/D regions 114-2 and 114-3). In other examples, one or more S/D regions may be coupled with a single nanoribbon or more than two nanoribbons.

The gate electrode material 108 is at least partially wrapping around the nanoribbons 104-1, 104-2, 104-3 and 104-4. In the example illustrated in FIG. 2E, the insulator material 206 separates and electrically isolates the portions 218-1 and 218-2 of the gate electrode material 108 from one another. Thus, in the example illustrated in FIG. 2E, the portion 218-1 of the gate electrode material 108 is at least partially around the nanoribbons 104-1 and 104-2, and the separate portion 218-2 of the gate electrode material 108 is at least partially around the nanoribbons 104-3 and 104-4.

Thus, in the example illustrated in FIG. 2E, the IC structure 200E includes two transistors 258-1 and 258-2, where a first transistor 258-1 has a first channel region in portions of the nanoribbons 104-1 and 104-2, and a second transistor 258-2 has a second channel region in portions of the nanoribbons 104-3 and 104-4. In the example illustrated in FIG. 2E, the first S/D region 114-1 and the third S/D region 114-3 are source or drain regions for the transistor 258-1, and the second S/D region 114-2 and the third S/D region 114-3 are source or drain regions for the transistor 258-2. In the example illustrated in FIG. 2E, a voltage 'A' is applied to the gate of the transistor 258-1, and a voltage 'B' is applied to the gate of the transistor 258-2. Because the S/D regions 114-1 and 114-2 of the transistors 258-1 and 258-2 are electrically isolated from one another and independent, the regions 114-1, and 114-2 may be at different voltages. For example, the S/D region 114-1 may be at the voltage V1, the S/D region 114-2 may be at the voltage V2. The S/D region 114-3 that is disposed opposite the S/D regions 114-1 and 114-2 across the channel regions may be at a voltage V3.

FIG. 2E illustrates an example circuit diagram 201E that may be formed with the IC structure 200E. As can be seen in FIG. 2E, an input 'A' is applied to the gate of the transistor 258-1, and the voltage 'B' is applied to the gate of the transistor 258-2. The transistors 258-1 and 258-2 each have one independent S/D terminal, which may be at the voltages V1 and V2, respectively. The other S/D terminals of the transistors 258-1 and 258-2 are tied together and may be at the voltage V3. Thus, in one example, the IC structure 200E may include two stacked nanoribbon-based transistors 258-1 and 258-2 with independent gates, one independent S/D terminal, and one shared S/D terminal.

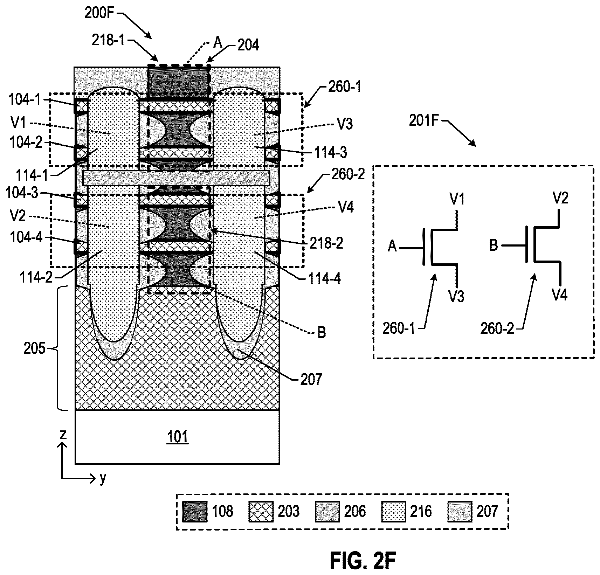

FIG. 2F illustrates another example of an IC structure 200F including a nanoribbon-based device with separate gate, source, and/or drain contacts and a corresponding circuit diagram 201F. The example illustrated in FIG. 2F includes a discontinuity in the gate electrode material 108 and a discontinuity in the source and drain regions to enable an IC structure 200F with two stacked transistors with separate portions of gate electrode material and separate S/D regions. For example, as can be seen in FIG. 2F, the IC structure 200F includes a first region (e.g., the region 114-1) of a doped semiconductor material in the stack 204, coplanar with the first nanoribbon 104-1 and second nanoribbon 104-2, and coupled with the first nanoribbon 104-1 and second nanoribbon 104-2, a second region (e.g., the region 114-2) of the doped semiconductor material in the stack 204, coplanar with the third nanoribbon 104-3 and the fourth nanoribbon 104-4, and coupled with the nanoribbons 104-3 and 104-4, a third region (e.g., the region 114-3) of the doped semiconductor material in the stack 204, where the third region 114-3 is coplanar with and coupled with the first nanoribbon 104-1 and the second nanoribbon 104-2, and a fourth region (e.g., the region 114-4) of the doped semiconductor material in the stack, where the fourth region 114-4 is coplanar with and coupled with the third nanoribbon 104-3 and the fourth nanoribbon 104-4.

An insulator material 206 is present between the first region 114-1 and the second region 114-2, and between the third region 114-3 and the fourth region 114-4. The regions 114-1 and 114-2 are vertically aligned in the stack 204 (e.g., the region 114-1 is over the region 114-2), and the regions 114-3 and 114-4 are vertically aligned in the stack 204. One of the first region 114-1 and the third region 114-3 is a source region and the other of the first region 114-1 and the third region 114-3 is a drain region of a first transistor 260-1. One of the second region 114-2 and the fourth region 114-4 is a source region and the other of the second region 114-2 and the fourth region 114-4 is a drain region of a second transistor 260-2. In the example illustrated in FIG. 2F, two nanoribbons are coupled with the same S/D regions (e.g., both the nanoribbons 104-1 and 104-2 are coupled with and coplanar with the S/D regions 114-1 and 114-3, and both the nanoribbons 104-3 and 104-4 are coupled with and coplanar with the S/D regions 114-2 and 114-4). In other examples, one or more S/D regions may be coupled with a single nanoribbon or more than two nanoribbons.

The gate electrode material 108 is at least partially wrapping around the nanoribbons 104-1, 104-2, 104-3 and 104-4. In the example illustrated in FIG. 2F, the insulator material 206 separates and electrically isolates the portions 218-1 and 218-2 of the gate electrode material 108 from one another. Thus, in the example illustrated in FIG. 2F, the portion 218-1 of the gate electrode material 108 is at least partially around the nanoribbons 104-1 and 104-2, and the separate portion 218-2 of the gate electrode material 108 is at least partially around the nanoribbons 104-3 and 104-4.

Thus, in the example illustrated in FIG. 2F, the IC structure 200F includes two transistors 260-1 and 260-2, where a first transistor 260-1 has a first channel region in portions of the nanoribbons 104-1 and 104-2, and a second transistor 260-2 has a second channel region in portions of the nanoribbons 104-3 and 104-4. In the example illustrated in FIG. 2F, the first S/D region 114-1 and the third S/D region 114-3 are source or drain regions for the transistor 260-1, and the second S/D region 114-2 and the fourth S/D region 114-4 are source or drain regions for the transistor 260-2. In the example illustrated in FIG. 2F, a voltage 'A' is applied to the gate of the transistor 260-1, and a voltage 'B' is applied to the gate of the transistor 260-2. Because both the source and drain regions of the transistors 260-1 and 260-2 are electrically isolated from one another and independent, the regions 114-1, 114-2, 114-3, and 114-4 may be at different voltages. For example, the S/D region 114-1 may be at the voltage V1, the S/D region 114-2 may be at the voltage V2, the S/D region 114-3 may be at the voltage V3, and the S/D region 114-4 may be at the voltage V4.

FIG. 2F illustrates an example circuit diagram 201F that may be formed with the IC structure 200F. As can be seen in FIG. 2F, an input 'A' is applied to the gate of the transistor 260-1, and the voltage 'B' is applied to the gate of the transistor 260-2. The transistors 260-1 and 260-2 each have two independent S/D terminals. For example, the S/D terminals of the transistor 260-1 may be at V1 and V3, and the S/D terminals of the transistor 260-2 may be at V2 and V4. Thus, in one example, the IC structure 200F may include two stacked nanoribbon-based transistors 260-1 and 260-2 with independent gates, independent source terminals, and independent drain terminals.

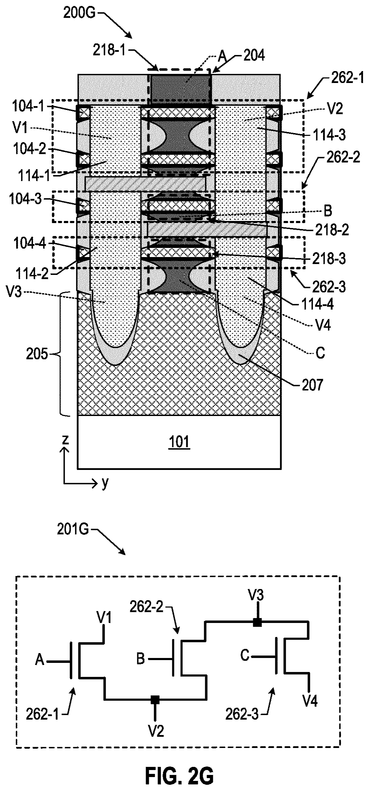

FIG. 2G illustrates another example of an IC structure 200G including a nanoribbon-based device with separate gate, source, and/or drain contacts and a corresponding circuit diagram 201G. The example illustrated in FIG. 2G includes two discontinuities in the gate electrode material 108 and a discontinuity in a source region, and a discontinuity in a drain region to enable an IC structure 200G with three stacked transistors with three separate portions of gate electrode material and four independent S/D regions. For example, as can be seen in FIG. 2G, the IC structure 200G includes a first region (e.g., the region 114-1) of a doped semiconductor material in the stack 204, coplanar with the first nanoribbon 104-1 and second nanoribbon 104-2, and coupled with the first nanoribbon 104-1 and second nanoribbon 104-2, a second region (e.g., the region 114-2) of the doped semiconductor material in the stack 204, coplanar with the third nanoribbon 104-3 and the fourth nanoribbon 104-4, and coupled with the nanoribbons 104-3 and 104-4, a third region (e.g., the region 114-3) of the doped semiconductor material in the stack 204, where the third region is coplanar with and coupled with the first nanoribbon 104-1, the second nanoribbon 104-2, and the third nanoribbon 104-3, and a fourth region (e.g., the region 114-4) of the doped semiconductor material in the stack 204, where the fourth region 114-4 is coplanar with and coupled with the fourth nanoribbon 104-4.

An insulator material 206 is present between the first region 114-1 and the second region 114-2, and between the third region 114-3 and the fourth region 114-4. In the example illustrated in FIG. 2G, the insulator material 206 between the first region 114-1 and second region 114-2 is in a different layer or plane than the insulator material 206 between the third region 114-3 and the fourth region 114-4. The regions 114-1 and 114-2 are vertically aligned in the stack 204 (e.g., the region 114-1 is over the region 114-2), and the regions 114-3 and 114-4 are vertically aligned in the stack 204. One of the first region 114-1 and the third region 114-3 is a source region and the other of the first region 114-1 and the third region 114-3 is a drain region of a first transistor 262-1. One of the second region 114-2 and the third region 114-3 is a source region and the other of the second region 114-2 and the third region 114-3 is a drain region of a second transistor 262-2. One of the second region 114-2 and the fourth region 114-4 is a source region and the other of the second region 114-2 and the fourth region 114-4 is a drain region of a third transistor 262-3.

The gate electrode material 108 is at least partially wrapping around the nanoribbons 104-1, 104-2, 104-3 and 104-4. In the example illustrated in FIG. 2G, the insulator material 206 separates and electrically isolates the portions 218-1 and 218-2 of the gate electrode material 108 from one another, and portions 218-2 and 218-3 of the gate electrode material 108 from one another. Thus, in the example illustrated in FIG. 2G, the portion 218-1 of the gate electrode material 108 is at least partially around the nanoribbons 104-1 and 104-2, the portion 218-2 is at least partially around the nanoribbon 104-3, and the portion 218-3 of the gate electrode material 108 is at least partially around the nanoribbon 104-4.

Thus, in the example illustrated in FIG. 2G, the IC structure 200G includes three transistors 262-1, 262-2, and 262-3, where a first transistor 262-1 has a first channel region in portions of the nanoribbons 104-1 and 104-2, a second transistor 262-2 has a second channel region in a portion of the nanoribbon 104-3, and a third transistor 262-3 has a third channel region in a portion of the nanoribbon 104-4. In the example illustrated in FIG. 2G, the first S/D region 114-1 and the third S/D region 114-3 are source or drain regions for the transistor 262-1, the second S/D region 114-2 and the third S/D region 114-3 are source or drain regions for the transistor 262-2, and the second S/D region 114-2 and the fourth S/D region 114-4 are source or drain regions for the transistor 262-3. In the example illustrated in FIG. 2G, a voltage 'A' is applied to the gate of the transistor 262-1, a voltage 'B' is applied to the gate of the transistor 262-2, and a voltage 'C' is applied to the gate of the transistor 262-3. The transistor 262-1 has one independent S/D region (e.g., the region 114-1) and an S/D region shared with the transistor 262-2 (e.g., the region 114-3). The transistor 262-2 has one S/D region shared with the transistor 262-1 (e.g., the region 114-3), and another S/D region shared with the transistor 262-3 (e.g., the region 114-2). The transistor 262-3 has one S/D region shared with the transistor 262-2 (e.g., the region 114-2) and another independent S/D region (e.g., the region 114-4).

FIG. 2G illustrates an example circuit diagram 201G that may be formed with the IC structure 200G. As can be seen in FIG. 2G, a voltage 'A' is applied to the gate of the transistor 262-1, the voltage 'B' is applied to the gate of the transistor 262-2, and the voltage 'C' is applied to the transistor 262-3. The transistor 262-1 has one independent S/D terminal (e.g., the terminal at V1) and an S/D terminal shared with the transistor 262-2 (e.g., the terminal at V2). The transistor 262-2 has one S/D terminal shared with the transistor 262-1 (e.g., the terminal at V2), and another S/D terminal shared with the transistor 262-3 (e.g., the terminal at V3). The transistor 262-3 has one S/D terminal shared with the transistor 262-2 (e.g., the terminal at V3) and another independent S/D terminal (e.g., the terminal at V4). Thus, in one example, the IC structure 200G may include three stacked nanoribbon-based transistors 262-1, 262-2, and 262-3 with independent gates and partially shared S/D terminals.

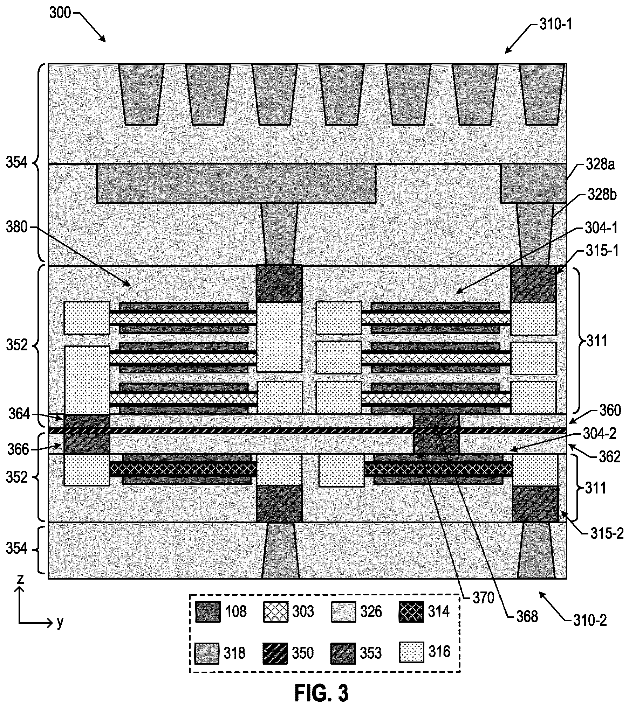

FIG. 3 is a cross-sectional side view of an example IC structure 300 that includes a nanoribbon-based device with a nanoribbon stack including a P-type nanoribbon and N-type nanoribbons and separate gate, source, and/or drain contacts.

The IC structure 300 includes two IC structures 310-1 and 310-2 (e.g., dies, wafers, or other IC structures) bonded together. Each of the IC structures 310-1 and 310-2 includes front end of line (FEOL) layers 352 and back end of line (BEOL) layers 354. A FEOL layer refers to a layer formed in the FEOL, such as a device layer or device region. In the FEOL, individual semiconductor devices components (e.g., transistors, capacitors, resistors, etc.) can be patterned in a wafer. A BEOL layer refers to a layer formed in the BEOL, such as an interconnect layer (e.g., metal layer) of a metallization stack. In the BEOL, interconnect structures such as conductive lines and conductive vias, separated as needed by an insulator material, can be formed to interconnect individual components. The BEOL usually starts with forming the first metal layer on the wafer. The first metal layer is often called M0. Additional metal layers can be formed on top of M0, and these metal layers are often called M1, M2, and so on. In the example illustrated in FIG. 3, the FEOL layer 352 includes a device region 311. The device region 311 may be disposed over a substrate; however, in various examples, some or all of the substrate may be removed prior to bonding the IC structures 310-1 and 310-2 with one another. The example in FIG. 3 depicts an IC structure 300 in which the substrates were removed prior to bonding. The device region 311 includes a plurality of devices. The devices may be frontend devices (e.g., frontend transistors such as FinFETs, nanowire transistors, nanoribbon transistors, frontend memory cells, and/or other frontend devices). The devices may include transistors of any architecture.

The BEOL layers 354 may include a plurality of backend interconnects electrically coupled to (e.g., in electrically conductive contact with at least portions of) one or more of the plurality of FEOL devices of the FEOL layer 352. Various BEOL interconnect layers 354 may be/include one or more metal layers of a metallization stack of the IC structure. Various metal layers of the BEOL interconnect layers 354 may be used to interconnect the various inputs and outputs of the devices (e.g., logic devices) in the FEOL layer 352. In one example, each of the BEOL interconnect layers 354 may include conductive interconnects 318, such as conductive vias and conductive lines/trenches. For example, the BEOL interconnect layers 354 includes a via portion 328b and a line or trench/interconnect portion 328a. The trench portion 328a of a metal layer is configured for transferring signals and power along electrically conductive (e.g., metal) lines (also sometimes referred to as "trenches") extending in the x-y plane (e.g., in the x or y directions), while the via portion 328b of a metal layer is configured for transferring signals and power through electrically conductive vias extending in the z-direction, e.g., to any of the adjacent metal layers above or below. Accordingly, in one example, vias connect metal structures (e.g., metal lines or vias) from one metal layer to metal structures of an adjacent metal layer. While referred to as "metal" layers, various layers of the BEOL interconnect layers 354 may include only certain patterns of conductive metals, e.g., copper (Cu), aluminum (Al), tungsten (W), or cobalt (Co), or metal alloys, or more generally, patterns of an electrically conductive material, formed in an insulating medium such as an ILD 326. Although the conductive interconnects are shown with the same shading, different conductive interconnects in different layers may be formed from different conductive materials. The insulating medium may include any suitable ILD materials such as silicon oxide, carbon-doped silicon oxide, silicon carbide, silicon nitride, aluminum oxide, and/or silicon oxynitride. In some embodiments, the ILD 326 disposed between the interconnect structures in different ones of the interconnect layers may have different compositions; in other embodiments, the composition of the ILD 326 between different interconnect layers may be the same.

In the example illustrated in FIG. 3, each IC structure 310-1 and 310-2 includes one or more nanoribbons. For example, the IC structure 310-1 includes a stack of nanoribbons 304-1 (in particular, three nanoribbons 304-1 stacked over one another) of a semiconductor material 303, and the IC structure 310-2 includes a nanoribbon 304-2 of a semiconductor material 314. The nanoribbons 304-1 and the nanoribbons 304-2 may be formed from different semiconductor materials (e.g., the semiconductor material 303 may have a different material composition than the semiconductor material 314). For example, one of the nanoribbons 304-1 and the nanoribbons 304-2 may be N-type nanoribbon(s) formed from an N-type semiconductor material and the other of the nanoribbons 304-1 and the nanoribbons 304-2 may be P-type nanoribbon(s) formed from a P-type semiconductor material. The N-type nanoribbons may form the basis of N-type nanoribbon-based transistors (i.e., NMOS transistors) and the P-type nanoribbons may form the basis of P-type nanoribbon-based transistors (i.e., PMOS transistors). Examples of semiconductor materials used to form the channel regions of NMOS transistors include silicon, III-V materials having a relatively high electron mobility, such as, but not limited to InGaAs, InP, InSb, and InAs. For some such embodiments, the channel material may be a ternary III-V alloy, such as InGaAs, GaAsSb, InAsP, or InPSb. Examples of semiconductor materials used to form the channel regions of PMOS transistors include a group IV material having a high hole mobility, such as, but not limited to Ge or a Ge-rich SiGe alloy. Other semiconductor materials are possible, and in some examples, the semiconductor material 303 and the semiconductor material 314 may have substantially the same material composition.

The nanoribbons 304-1 and 304-2 may form the basis of transistors that include separate gate, source, and/or drain contacts in accordance with examples described herein. For example, the IC structure 300 includes a gate electrode material 108 at least partially around the nanoribbons 304-1 and 304-2, and regions of a doped semiconductor material 316. In the example illustrated in FIG. 3, there are separate portions (e.g., portions that are electrically isolated from one another) of the gate electrode material 108 around different nanoribbons 304-1. Similarly, there are separate regions of the doped semiconductor material 316 to form independent S/D regions coupled with some of the nanoribbons 304-1. The example illustrated in FIG. 3 depicts some contact structures 353, while others may not be visible in the cross-section shown in FIG. 3.

In the example illustrated in FIG. 3, the IC structure 310-1 is hybrid bonded with the IC structure 310-2. In hybrid bonding, the bonding process is between a first layer (e.g., the layer 360) of a first IC structure 310-1 and a second layer (e.g., the layer 362) of a second IC structure 310-2 and is also between conductive structures within the first layer 360 and conductive structures within the second layer 362. For example, in hybrid bonding, a conductive structure (e.g., a conductive via, contact structure, or other conductive element) extends through each of the first and second layers 360 and 362, prior to these layers being bonded to form the bonding interface layer. For example, a first conductive structure 364 extends through the first layer 360 and is exposed through, and flush with, a surface of the first layer 360; and a second conductive structure 366 extends through the second layer 362 and is exposed through, and flush with, a surface of the second layer 362 (e.g., prior to the bonding process). During the bonding process, surfaces of the first layer 360 and the second layer 362 bond to form a bonding interface 350, along with a bonding or contact of the first conductive structure 364 and the second conductive structure 364. In the IC structure 300 of FIG. 3, the bonding interface 350 is present between a face (e.g., the back side) of the IC structure 310-1 and a face (e.g., the back side) of the IC structure 310-2. The conductive structures in adjacent stacked dies that are bonded together may be, for example, conductive vias, conductive pads, or any other suitable conductive elements that may be bonded together via a hybrid bonding process. In one example, due to unintentional practical considerations of the bonding process, the conductive structures of the first and second layers 360 and 362 may not be perfectly aligned during the bonding process. Accordingly, sections of a combined conductive structure formed through a hybrid bonding process, which extend through the bonding interface 350, may have some misalignment or offset.

In some embodiments, bonding may be performing using insulator-insulator bonding, e.g., as oxide-oxide bonding, where an insulator of one the IC structure 310-1 is bonded to an insulator material of the IC structure 310-2. In some examples, an insulator material may be provided over the back sides of the IC structures 310-1 and 310-2 for the purposes of bonding. In some embodiments, a bonding material may be present in between the faces that are bonded together (e.g., the bonding interface 350 in the IC structure 300 may include a bonding material). To that end, the bonding material may be applied to the one or both faces that are to be bonded and then the faces are put together, possibly while applying a suitable pressure and heating up the assembly to a suitable temperature (e.g., to moderately high temperatures, e.g., between about 50 and 200 degrees Celsius) for a duration of time. In some embodiments, the bonding material may be an adhesive material that ensures attachment of the faces of different IC structures to one another. In some embodiments, the bonding material may be an etch-stop material. In some embodiments, the bonding material may be both an etch-stop material and have suitable adhesive properties to ensure attachment of the first and second IC structures to one another. In some embodiments, the bonding material may include silicon, nitrogen, and carbon, where the atomic percentage of any of these materials may be at least 1%, e.g., between about 1% and 50%, indicating that these elements are added deliberately, as opposed to being accidental impurities which are typically in concentration below about 0.1%. Having both nitrogen and carbon in these concentrations in addition to silicon is not typically used in conventional semiconductor manufacturing processes where, typically, either nitrogen or carbon is used in combination with silicon, and, therefore, could be a characteristic feature of the hybrid bonding. Using at the bonding interface 350 an etch-stop material that includes include silicon, nitrogen, and carbon, where the atomic percentage of any of these materials may be at least 1%, e.g., SiOCN, may be advantageous in terms that such a material may act both as an etch-stop material, and have sufficient adhesive properties to bond the IC structures 310-1 and 310-2 together.

In some embodiments, no bonding material may be used, but there will still be a bonding interface (e.g., the bonding interface 350) resulting from the bonding of the IC structures 310-1 and 310-2. Such a bonding interface may be recognizable as a seam or a thin layer in the microelectronic assembly, using, e.g., selective area diffraction (SED), even when the specific materials of the insulators that are bonded together may be the same, in which case the bonding interface would still be noticeable as a seam or a thin layer in what otherwise appears as a bulk insulator layer.

In the example illustrated in FIG. 3, where the bonding interface 350 is between the back side of the IC structure 310-1 and the back side of the IC structure 310-2, the taper of the conductive interconnects in the BEOL interconnect layers 354 of the IC structure 310-1 may be in the opposite direction relative to the taper of conductive interconnects in the BEOL interconnect layers 354 of the IC structure 310-2. The conductive interconnects in the BEOL interconnect layers 354 of the IC structures 310-1 and 310-2 may be coupled with contact structures in the respective IC structures 310-1 and 310-2. For example, a first conductive via of the IC structure 310-1 may be coupled (e.g., directly coupled) with a first contact structure (e.g., the contact structure 315-1), a second conductive via of the IC structure 310-2 may be coupled (e.g., directly coupled) with a second contact structure (e.g., the contact structure 315-2), where the first conductive via tapers in an opposite direction relative to the second conductive via.

In the example illustrated in FIG. 3, as a result of the hybrid bonding, a stack of nanoribbons that includes both an N-type nanoribbon and a P-type nanoribbon may be formed. For example, the IC structure 300 includes a stack of four nanoribbons (e.g., three N-type nanoribbons stacked over one P-type nanoribbon). In the example illustrated in FIG. 3, the hybrid bonding interface 350 is between the nanoribbon 304-2 and a bottom nanoribbon of the nanoribbons 304-2 of the combined nanoribbon stack. As mentioned briefly above, some conductive structures in each of the IC structures 310-1 and 310-2 may be bonded with one another at the bonding interface 350. In some examples, a conductive material, such as a portion of a contact structure, may be present between the S/D regions in the IC structure 310-1 and the IC structure 310-2, and/or between the gate electrode material 108 in the IC structure 310-1 and the IC structure 310-2. For example, the first conductive structure 364 of the IC structure 310-1 may be bonded with the second conductive structure 366 of the IC structure 310-2 to form a combined contact structure that electrically couples an S/D region in the IC structure 310-1 with an S/D region of the IC structure 310-2. Similarly, a conductive structure 368 of the IC structure 310-1 may be bonded with a conductive structure 370 of the IC structure 310-2 to form a combined contact structure that electrically couples a portion of gate electrode material 108 in the IC structure 310-1 with a portion of the gate electrode material 108 in the IC structure 310-2. In one such example, an IC device 380 that includes stacked NMOS and PMOS transistors may be formed to implement a variety of CMOS circuits in a compact area.

Although FIG. 3 illustrates an example in which the IC structure 310-1 includes three stacked nanoribbons and the IC structure 310-2 includes one nanoribbon, different embodiments may include different numbers of nanoribbons in each of the IC structures 310-1, 310-2 (e.g., one, two, three, four, or more than four). Additionally, although a specific example of gate and S/D contacts is shown in FIG. 3, the examples related to hybrid bonding and stacking may apply to any of the example IC structures with separate gate, source, and/or drain contacts described herein. Furthermore, each of the bonded IC structures may include P-type nanoribbons, N-type nanoribbons, or both N-type and P-type nanoribbons from which an IC device with separate gate, source, and/or drain contacts are implemented.

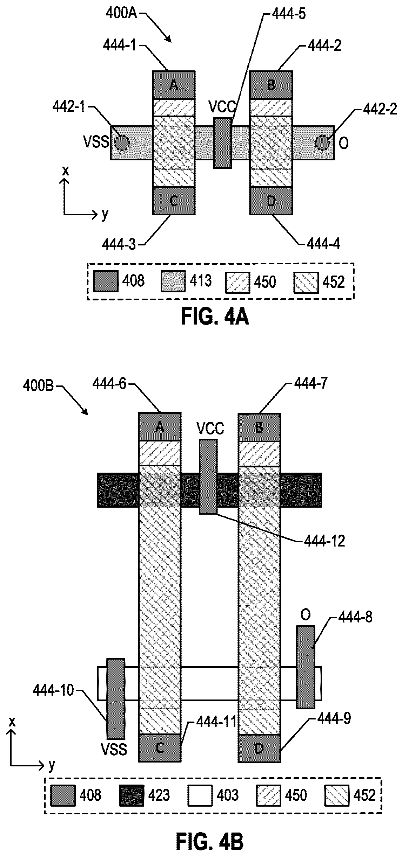

FIGS. 4A-4B are top-down plan views of IC structures that include nanoribbon-based devices with separate gate, source, and/or drain contacts, in accordance with some embodiments of the present disclosure. FIG. 4A illustrates an example of contact structures in a single stack of nanoribbons (e.g., an NP-type stack 413 that includes both an N-type and a P-type nanoribbon). FIG. 4B illustrates an example of contact structures 408 in two adjacent stacks of nanoribbons (e.g., an N-type stack 403 adjacent to a P-type stack 423). In both FIGS. 4A and 4B, inputs ('A', 'B', 'C', 'D', VSS, and VCC) and an output ('O') are labeled. In the examples illustrated in FIGS. 4A and 4B, the inputs 'A', 'B', 'C', and 'D' are applied to various gate contacts of transistors of the IC structures 400A and 400B, and VSS and VCC are applied to various S/D contacts of transistors of the IC structures 400A and 400B. Some contact structures 408 may couple with portions of gate electrode material in different layers, and may therefore a portion of the conductive material of such contact structures 408 may be coplanar with one or more nanoribbons. Portions of gate electrode material in different layers (e.g., around different nanoribbons) is shown with a different pattern. For example, the portion 450 of gate electrode material may be in a layer or plane above the portion 452 of gate electrode material.

Referring first to FIG. 4A, the IC structure 400A includes the stack 413 with two or more nanoribbons stacked over one another, where at least one of the nanoribbons is a P-type nanoribbon, and another one of the nanoribbons is an N-type nanoribbon. However, in other examples, the nanoribbons in the stack 413 may all be of one type (e.g., all N-type or all P-type). The example illustrated in FIG. 4A depicts both frontside contacts 444-1, 444-2, 444-3, 444-4, and 444-5 and backside contacts 442-1 and 442-2. In one example, a frontside contact may be formed over the portions 450, 452 of gate electrode material. A backside contact may be formed by flipping over the device, forming an opening in the backside of the IC structure to expose the material for which the backside contact is to be formed (e.g., the doped semiconductor material of an S/D region) and forming the contact structure from a backside of the IC structure.

FIG. 4B illustrates an example of an IC structure 400B with two stacks 403 and 423, and frontside contacts 444-6, 444-7, 444-8, 444-9, 444-10, 444-11, and 444-12. Thus, unlike the example in FIG. 4A that included a combination of frontside and backside contact structures, the IC structure 400B includes all frontside contact structures.

In the examples illustrated in both FIGS. 4A and 4B, the gate electrode material may extend orthogonally relative to the nanoribbons (e.g., along the x-axis shown in FIGS. 4A and 4B) to enable forming independent contacts with different nanoribbons in the stack(s). As a result, some, or all of the frontside contacts may not be aligned directly over the nanoribbons. For example, consider the portion 452 of gate electrode material, which may wrap at least partially around a nanoribbon in the middle or bottom nanoribbon (e.g., not the top nanoribbon) of the stacks 413, 403, and 423. In one such example, the portion 452 may extend past the edge of the nanoribbons of the stacks 413 and 403 (e.g., in the negative x-direction as shown in FIG. 4B). In the example illustrated in FIGS. 4A and 4B, the contact structures coupled with the portion 452 (e.g., the contact 444-3 of FIG. 4A and the contact 444-11 of FIG. 4B) may be disposed beyond the edge of the nanoribbons. In one such example, contact structures coupled with the portion 452 (e.g., the frontside contact 444-3 of FIG. 4A and the frontside contact 444-11 of FIG. 4B) may include a portion of conductive material that is coplanar with one or more nanoribbons of the stacks 413 and 403 (e.g., the portion of conductive material of the contacts 444-3 and 444-11 may extend into the page in the z-direction as shown in FIGS. 4A and 4B to make contact with the portion 452) of gate electrode material.

In this example, now consider the portion 450 of gate electrode material, which may wrap at least partially around a top nanoribbon of the stacks 413, 403, and 423. In one such example, a contact structure coupled with the portion 450 (e.g., the contact 444-1 of FIG. 4A and the contact 444-6 of FIG. 4B) may also be disposed beyond an edge of the nanoribbons (e.g., in the opposite direction relative to the contact structures coupled with the portions 452). For example, the contact 444-1 and the contact 444-3 are on either side of the stack 413 (e.g., beyond edges of the nanoribbons). Thus, in some examples, different frontside contacts may be coplanar with one another and coupled with gate electrode material around different nanoribbons in a stack. In one such example, because the portion 452 is in a higher-up layer than the portion 450, a portion of the contacts 444-3 and 444-11 may be coplanar with the portions 450 of gate electrode material coupled with the contacts 444-1 and 444-6. Other contact structures (e.g., any of the frontside contacts shown in FIGS. 4A and 4B) may be disposed partially or entirely beyond the edges of the nanoribbons rather than being aligned over the nanoribbons.

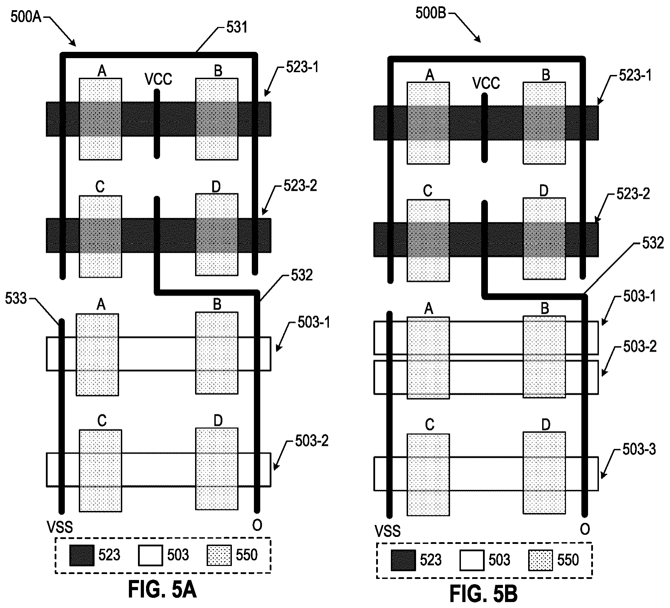

FIGS. 5A-5D are diagrams of IC structures that include nanoribbon-based devices with separate gate, source, and/or drain contacts and examples of interconnections, in accordance with some embodiments of the present disclosure. As mentioned above, various examples, IC structures may include conductive interconnects that are between nanoribbons in a stack, and/or between and coplanar with adjacent stacks of nanoribbons to form interconnects amongst contacts in order to implement circuits. The examples illustrated in FIGS. 5A-5D depict interconnects for implementing an and-or-invert (AOI) circuit with the equation O = !(AB+CD), where 'A', 'B', 'C', and 'D' are inputs and 'O' is the output. Other circuits may similarly be implemented in accordance with examples described herein.

FIG. 5A depicts a diagram of an IC structure 500A with two P-type nanoribbons 523 and two N-type nanoribbons 503. In one example, the nanoribbons 523 may form a first stack, and the nanoribbons 503 may form a second stack that is adjacent to the first stack. For example, the nanoribbon 523-1 may be stacked over the nanoribbon 523-2, and the nanoribbon 503-1 may be stacked over the nanoribbon 503-2. A gate electrode material 550 is at least partially around the nanoribbons 503 and 523. In the example illustrated in FIG. 5A, two transistors are implemented in each of the nanoribbons 523-1, 523-2, 503-1, and 503-2. Therefore, the IC structure 500A implements a circuit with eight nanoribbon-based transistors, including four NMOS transistors and four PMOS transistors.

As can be seen in FIG. 5A, the inputs 'A' and 'B' are applied to the gates of the transistors formed from the nanoribbon 523-1 and to the gates of the transistors formed from the nanoribbon 503-1. The inputs 'C' and 'D' are applied to the gates of the transistors formed from the nanoribbon 523-2 and to the gates of the transistors formed from the nanoribbon 503-2. A conductive interconnect 531 couples one S/D region of each of the transistors formed in the nanoribbons 523-1 and 523-2 together. The other S/D region of the transistors formed in the nanoribbon 523-1 are coupled to VCC. The other S/D region of the transistors formed in the nanoribbon 523-2 are coupled (with a conductive interconnect 532) to the output 'O' and to an S/D region of a transistor formed in the nanoribbon 503-1 and to an S/D region of a transistor formed in the nanoribbon 503-2. A conductive interconnect 533 couples an S/D region of the other transistor formed in the nanoribbon 503-1 and an S/D region of the other transistor formed in the nanoribbon 503-2 to VSS. As can be seen in FIG. 5A, the conductive interconnect 532 couples together the contacts of transistors formed in different nanoribbons in the stack. In one such example, the conductive interconnect 532 may include a portion between the two stacks of nanoribbons, and in a layer with one or more of the nanoribbons 503 and 523.

FIG. 5B illustrates a diagram of another IC structure 500B. The IC structure 500B is similar to the IC structure 500A, but with an additional N-type nanoribbon. As can be seen in FIG. 5B, the IC structure 500B includes two P-type nanoribbons 523-1 and 523-2, and three N-type nanoribbons 503-1, 503-2, and 503-3. In the example illustrated in FIG. 5B, the transistors formed from the nanoribbons 503-1 and 503-2 may have shared gate contacts (e.g., similar to the transistor 260-1 of FIG. 2F). Thus, the adjacent stacks of nanoribbons may have different numbers of nanoribbons. The IC structure 500B also includes the conductive interconnect 532 between a nanoribbon of the first stack (e.g., the nanoribbon 523-2) and a nanoribbon of the second stack (e.g., the nanoribbon 503-1).

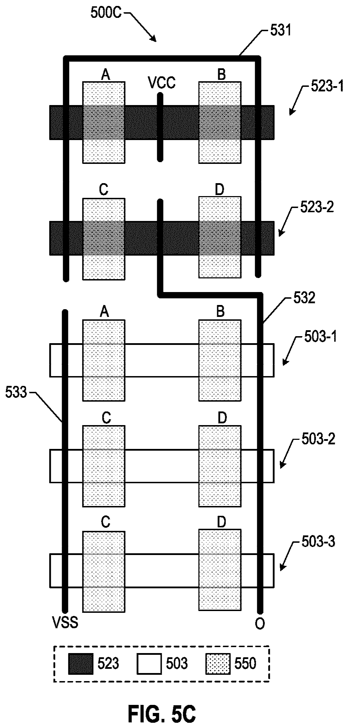

FIG. 5C illustrates a diagram of another IC structure 500C. The IC structure 500C is similar to the IC structure 500B, but the transistors formed in the nanoribbons 503-1 and 503-2 have separate gate contacts. As can be seen in FIG. 5C, the IC structure 500C includes two P-type nanoribbons 523-1 and 523-2, and three N-type nanoribbons 503-1, 503-2, and 503-3. In the example illustrated in FIG. 5C, although the gates of the transistors formed from the nanoribbons 503-2 and 503-3 are coupled with the same inputs (e.g., 'C' and 'D'), the gates of the transistors in the nanoribbons 503-2 and 503-3 may be independent.

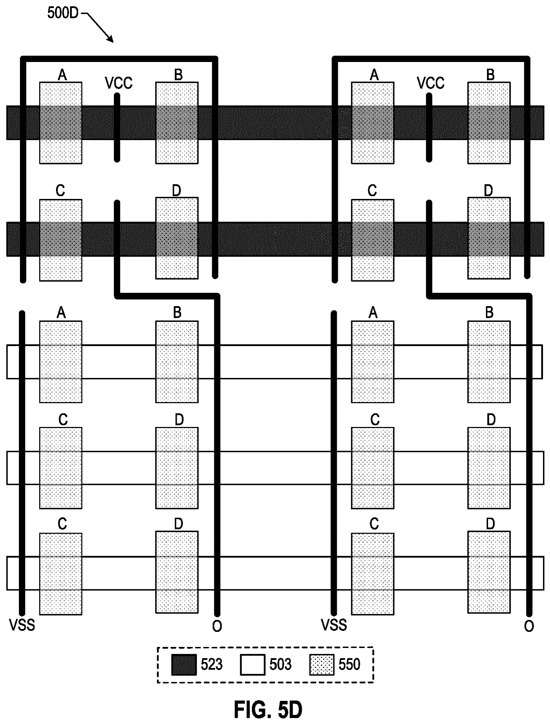

FIG. 5D illustrates a diagram of another IC structure 500D. The IC structure 500D is similar to the IC structures of FIGS. 5A-5C, but includes a tiled variation in which the transistors and interconnections may be repeated in different portions of the nanoribbon stack(s).

Although the examples described above with respect to FIGS. 5A-5D discuss two adjacent stacks of nanoribbons, the interconnections shown in FIGS. 5A-5D may similarly be implemented with a single stack of nanoribbons. For example, referring again to FIG. 5A, the nanoribbons 523-1, 523-2, 503-1, and 503-2 may all be stacked over one another to form a single stack. In one such example, a bonding interface may be present between the nanoribbon 523-2 and the nanoribbon 503-1. In one such example, the conductive interconnect 532 may include a portion that is between the nanoribbon 503-1 and the nanoribbon 523-2 (e.g., a conductive interconnect between and substantially aligned with the nanoribbons 503-1 and 523-2, and which may further extend in a direction parallel with the nanoribbons 503-1 and 523-2).

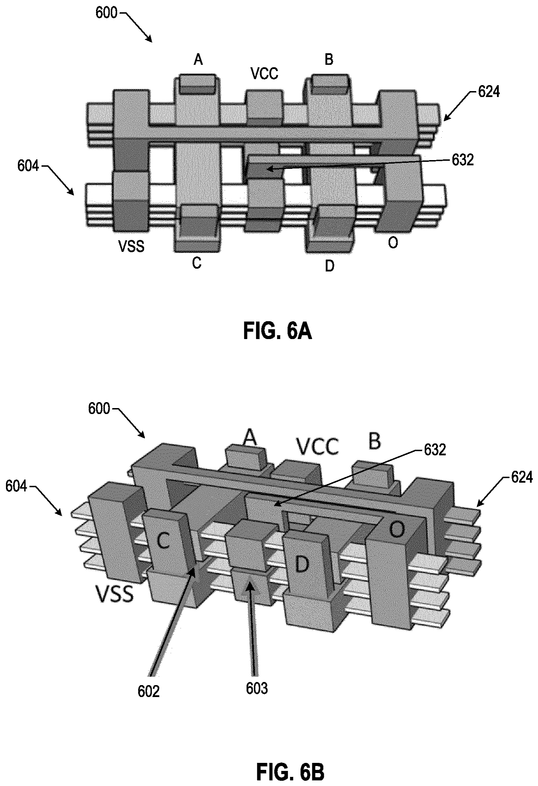

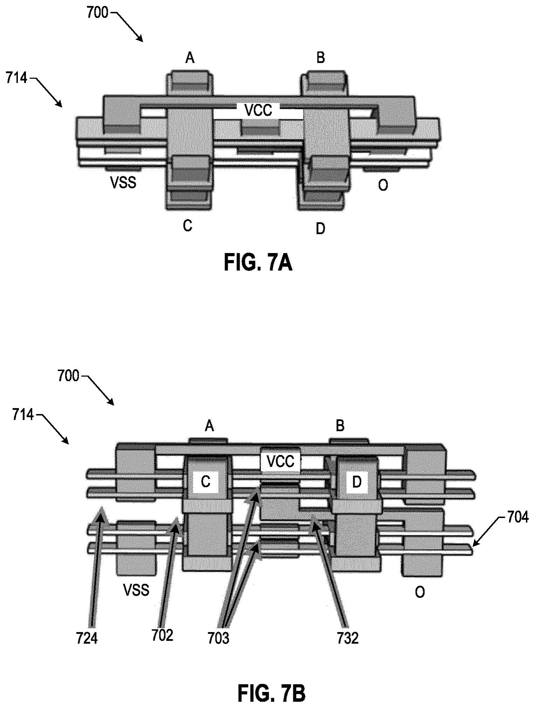

FIGS. 6A-6B and 7A-7B are perspective views of an example IC structure that includes a nanoribbon-based device with separate gate, source, and/or drain contacts, in accordance with some embodiments of the present disclosure. The IC structures of FIGS. 6A-6B and 7A-7B implement the AOI circuit discussed above with respect to FIGS. 5A-6D. FIGS. 6A-6B illustrate different views of an IC structure 600 that includes two adjacent stacks of nanoribbons, and FIGS. 7A-7B illustrate different views of an IC structure 700 that includes a single stack of nanoribbons.

Referring first to FIGS. 6A-6B, the IC structure 600 includes a stack 604 of N-type nanoribbons and a stack 624 of P-type nanoribbons, where each of the stacks 604 and 624 include four nanoribbons. A metal gate 602 surrounds channel portions of the nanoribbons. Cuts or discontinuities 603 between contacts enable independent contacts. A conductive interconnect 632 may be coupled with contacts of transistors in each of the stacks 604, 624, where the conductive interconnect 632 is coplanar with the stacks 604, 624, and between the stacks 604, 624.

Referring now to FIGS. 7A-7B, the IC structure 700 includes a stack 714 with both N-type nanoribbons 704 and P-type nanoribbons 724. In the example illustrated in FIGS. 7A-7B, the IC structure 700 includes two N-type nanoribbons 704 and two P-type nanoribbons 724. A metal gate 702 surrounds channel portions of the nanoribbons 704 and 724. Cuts or discontinuities 703 between contacts enable independent contacts. A conductive interconnect 732 may be coupled with independent contacts of transistors in the different nanoribbons. In the example illustrated in FIGS. 7A-7B, a portion of the conductive interconnect 732 is between and aligned with the bottom one of the P-type nanoribbons and a top one of the N-type nanoribbons.

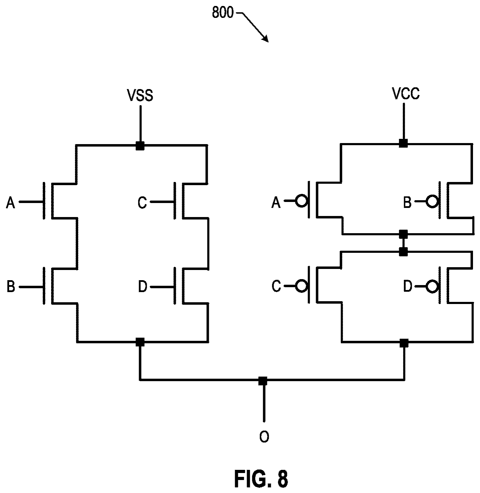

FIG. 8 is a circuit diagram 800 of the example IC structures of FIGS. 6A-6B and 7A-7B, in accordance with some embodiments of the present disclosure. The circuit diagram 800 depicts an example of a CMOS implementation of an AOI circuit that includes four NMOS transistors and four PMOS transistors. There are four inputs 'A', 'B', 'C', and 'D' and an output 'O'. The output 'O' will be low (e.g., logic 0) if both (A OR B) AND (C OR D) are true. The output 'O' will be high (e.g., logic 1) if either (A AND B) are false OR (C AND D) are false.

Accordingly, a nanoribbon-based device with separate gate, source, and/or drain contacts may enable forming a circuit including multiple stacked transistors in a single nanoribbon stack. Conductive interconnects that are coplanar with one or more nanoribbons of the stack may enable interconnecting the separate contacts of the stacked transistors with one another to form a variety of circuits, including CMOS circuits, with a small footprint.

IC structures including a nanoribbon-based device with separate gate, source, and/or drain contacts as described herein (e.g., as described with reference to FIGS. 1, 2A-2G, 3, 4A-4B, 5A-5D, 6A-6B, 7A-7B, and 8) may be used to implement any suitable components. For example, in various embodiments, IC devices described herein may be part of one or more of: a central processing unit, a memory device (e.g., a high-bandwidth memory device), a memory cell, a logic circuit, input/output circuitry, a field programmable gate array (FPGA) component such as an FPGA transceiver or an FPGA logic, a power delivery circuitry, an amplifier (e.g., a III-V amplifier), Peripheral Component Interconnect Express (PCIE) circuitry, Double Data Rate (DDR) transfer circuitry, a computing device (e.g., a wearable or a handheld computing device), etc.

The IC devices/structures disclosed herein, e.g., the IC structures 200A, 200B, 200C, 200D, 200E, 200F, 200G, 300, 400A, 400B, 500A, 500B, 500C, 500D, 600, 700, or any variations thereof, may be included in any suitable electronic component. FIGS. 9-12 illustrate various examples of apparatuses that may include any of the IC devices disclosed herein.

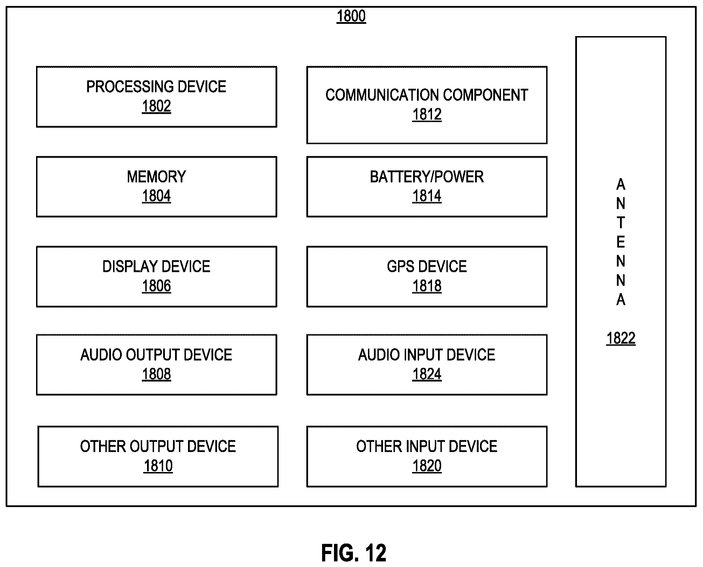

FIG. 9 is a top view of a wafer 1500 and dies 1502 that may include one or more IC structures in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more IC structures as described herein (e.g., any of the IC structures 200A, 200B, 200C, 200D, 200E, 200F, 200G, 300, 400A, 400B, 500A, 500B, 500C, 500D, 600, 700, or any variations thereof described herein, or any combination of such IC structures), one or more transistors and/or supporting circuitry to route electrical signals to the transistors, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 12) or other logic that is configured to store information in the memory devices or execute instructions stored in the memory array.

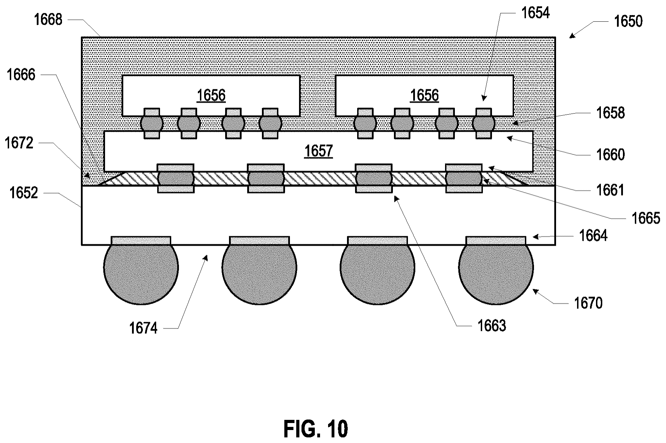

FIG. 10 is a side, cross-sectional view of an example IC package 1650 that may include one or more IC structures in accordance with any of the embodiments disclosed herein (e.g., any of the IC structures 200A, 200B, 200C, 200D, 200E, 200F, 200G, 300, 400A, 400B, 500A, 500B, 500C, 500D, 600, 700, or any variations thereof described herein, or any combination of such IC structures). In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 10 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 10 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

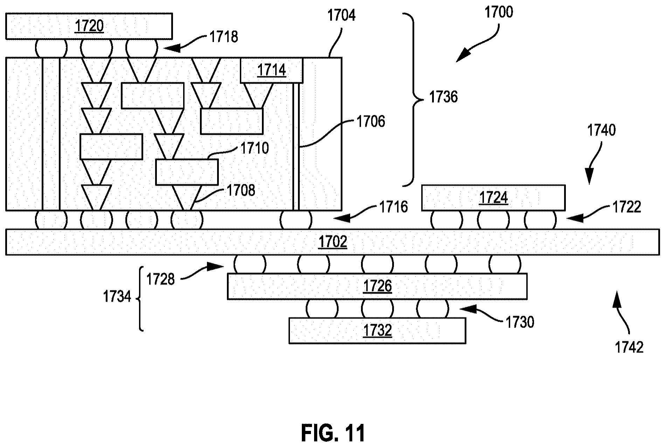

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 10 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 11.

The dies 1656 may take the form of any of the embodiments of the die 1502 discussed herein. In embodiments in which the IC package 1650 includes multiple dies 1656, the IC package 1650 may be referred to as a multi-chip package (MCP). The dies 1656 may include circuitry to perform any desired functionality. For example, one or more of the dies 1656 may be logic dies (e.g., silicon-based dies), and one or more of the dies 1656 may be memory dies (e.g., high-bandwidth memory).

Although the IC package 1650 illustrated in FIG. 10 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 10, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 11 is a side, cross-sectional view of an IC device assembly 1700 that may include one or more IC packages or other electronic components (e.g., a die) including one or more IC devices in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 10 (e.g., may include one or more of the IC structures 200A, 200B, 200C, 200D, 200E, 200F, 200G, 300, 400A, 400B, 500A, 500B, 500C, 500D, 600, 700, or any variations thereof described herein, or any combination of such IC structures).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 11 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 11), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 11, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 9), an IC device (e.g., any of the IC structures 200A, 200B, 200C, 200D, 200E, 200F, 200G, 300, 400A, 400B, 500A, 500B, 500C, 500D, 600, 700, or any variations thereof described herein, or any combination of such IC structures), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 11, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 11 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 12 is a block diagram of an example electrical device 1800 that may include one or more IC structures 100 in accordance with any of the embodiments disclosed herein. For example, any suitable ones of the components of the electrical device 1800 may include one or more of the IC device assemblies 1700, IC packages 1650, or dies 1502 disclosed herein. A number of components are illustrated in FIG. 12 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 12, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra-mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultra book computer, a personal digital assistant (PDA), an ultra-mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure, including a stack of two or more nanoribbons, where the stack includes a first nanoribbon and a second nanoribbon; a first portion of a gate electrode material at least partially around the first nanoribbon; a second portion of the gate electrode material at least partially around the second nanoribbon; an insulator material between the first portion and the second portion; a first contact structure coupled with the first portion; and a second contact structure coupled with the second portion.

Example 2 provides the IC structure of example 1, further including a first region of a doped semiconductor material in the stack, coplanar with the first nanoribbon, and coupled with the first nanoribbon; a second region of the doped semiconductor material in the stack, over the first region, coplanar with the second nanoribbon, and coupled with the second nanoribbon; and the insulator material between the first region and the second region.

Example 3 provides the IC structure of example 2, further including a third region of the doped semiconductor material in the stack, coplanar with the first nanoribbon, and coupled with the first nanoribbon (wherein one of the first region and the third region is a source region and the other of the first region and the second region is a drain region of a first transistor); a fourth region of the doped semiconductor material in the stack, over the third region, coplanar with the second nanoribbon, and coupled with the second nanoribbon (wherein one of the second region and the fourth region is a source region and the other of the second region and the fourth region is a drain region of a second transistor); and the insulator material between the third region and the fourth region.

Example 4 provides the IC structure of any one of examples 1-3, where the stack includes a third nanoribbon, and where the IC structure further includes a third portion of the gate electrode material at least partially around the third nanoribbon; the insulator material between the second portion and the third portion; and a third gate contact structure coupled with the third portion.

Example 5 provides the IC structure of any one of examples 1-3, where: the stack includes a third nanoribbon, and the second portion is at least partially around the third nanoribbon.

Example 6 provides the IC structure of any one of examples 4-5, where the stack includes a fourth nanoribbon, and where the IC structure further includes a fourth portion of the gate electrode material at least partially around the fourth nanoribbon; the insulator material between the third portion and the fourth portion; and a fourth gate contact structure coupled with the fourth portion.

Example 7 provides the IC structure of any one of examples 4-5, where: the stack includes a fourth nanoribbon between the first nanoribbon and the second nanoribbon, and the first portion is at least partially around the fourth nanoribbon.

Example 8 provides the IC structure of any one of examples 1-7, where: the first contact structure is coplanar with the second nanoribbon.

Example 9 provides the IC structure of any one of examples 1-8, where: the first contact structure and the second contact structure are on either side of the stack (e.g., beyond edges of the nanoribbons).

Example 10 provides the IC structure of any one of examples 1-9, where: a first transistor has a first channel region in the first nanoribbon, and a second transistor has a second channel region in the second nanoribbon.

Example 11 provides the IC structure of any one of examples 1-10, where the stack is a first stack, the two or more nanoribbons are two or more first nanoribbons, and where the IC structure further includes a second stack of two or more second nanoribbons, where the second stack is adjacent to the first stack, the second stack includes a third nanoribbon and a fourth nanoribbon; and a conductive interconnect between the first nanoribbon with the third nanoribbon.

Example 12 provides the IC structure of example 11, where: the conductive interconnect is coplanar with and between the first stack and the second stack.

Example 13 provides the IC structure of any one of examples 11-12, where: the first two or more nanoribbons include an N-type semiconductor material, and the second two or more nanoribbons include a P-type semiconductor material.

Example 14 provides the IC structure of any one of examples 1-12, where: the first nanoribbon includes an N-type semiconductor material, and the second nanoribbon includes a P-type semiconductor material.

Example 15 provides the IC structure of example 14, further including a hybrid bonding interface between the first nanoribbon and the second nanoribbon.

Example 16 provides the IC structure of any one of examples 14-15, where: the second nanoribbon is stacked over the first nanoribbon, a first conductive via is coupled (e.g., directly coupled) with the first contact structure, a second conductive via is coupled (e.g., directly coupled) with the second contact structure, and the first conductive via tapers in an opposite direction relative to the second conductive via.

Example 17 provides an IC structure, including a first nanoribbon; a second nanoribbon stacked over the first nanoribbon; a first region of a doped semiconductor material in the first nanoribbon in a plane that is substantially orthogonal to the first nanoribbon; a second region of the doped semiconductor material in the second nanoribbon, where the second region is over the first region in the plane; and an insulator material between the first region and the second region.

Example 18 provides the IC structure of example 17, further including; a third region of the doped semiconductor material in the first nanoribbon and coplanar with the first region; a fourth region of the doped semiconductor material in the second nanoribbon and coplanar with the second region; the insulator material between the third region and the fourth region; and a gate electrode material at least partially wrapping around the first nanoribbon and the second nanoribbon.

Example 19 provides the IC structure of example 18, where: the gate electrode material includes a continuous portion of the gate electrode material between the first nanoribbon and the second nanoribbon.

Example 20 provides the IC structure of example 18, where: the gate electrode material includes a discontinuity between the first nanoribbon and the second nanoribbon, and the discontinuity includes the insulator material.

Example 21 provides the IC structure of any one of examples 17-20, where one or more features are in accordance with examples 4-16.

Example 22 provides an IC structure, including a first stack of nanoribbons; a second stack of nanoribbons adjacent to and coplanar with the first stack; a first transistor with a first channel region in the first stack, where the first transistor includes a first contact structure; a second transistor with a second channel region in the second stack, where the second transistor includes a second contact structure; and a conductive interconnect coupled with the first contact structure and the second contact structure, coplanar with the first stack, and between the first stack and the second stack.

Example 23 provides the IC structure of example 22, where: the conductive interconnect includes a first interconnect portion that is substantially parallel to a nanoribbon of the first stack, and a second interconnect portion that is substantially orthogonal to the nanoribbon, where the second interconnect portion is coplanar with first stack and between the first stack and the second stack.

Example 24 provides an IC structure, including a stack of nanoribbons including at least a first nanoribbon and a second nanoribbon stacked over the first nanoribbon; a first transistor with a first channel region in the first nanoribbon; a second transistor with a second channel region in the second nanoribbon; a first gate electrode coupled with the first channel region; a second gate electrode coupled with the second channel region; and a contact structure coplanar with the second nanoribbon and coupled with the first gate electrode.

Example 25 provides an IC structure according to any one of examples 1-24, where the IC structure includes or is a part of a central processing unit.

Example 26 provides an IC structure according to any one of examples 1-25, where the IC structure includes or is a part of a memory device.

Example 27 provides an IC structure according to any one of examples 1-26, where the IC structure includes or is a part of a logic circuit.

Example 28 provides an IC structure according to any one of examples 1-27, where the IC structure includes or is a part of input/output circuitry.

Example 29 provides an IC structure according to any one of examples 1-28, where the IC structure includes or is a part of a field programmable gate array transceiver.

Example 30 provides an IC structure according to any one of examples 1-30, where the IC structure includes or is a part of a field programmable gate array logic.

Example 31 provides an IC structure according to any one of examples 1-30, where the IC structure includes or is a part of a power delivery circuitry.

Example 32 provides an IC package that includes an IC die including an IC structure according to any one of examples 1-31; and a further IC component, coupled to the IC die.

Example 33 provides an IC package according to example 32 where the further IC component includes a package substrate.

Example 34 provides an IC package according to example 32, where the further IC component includes an interposer.

Example 35 provides an IC package according to example 32, where the further IC component includes a further IC die.

Example 36 provides a computing device that includes a carrier substrate and an IC structure coupled to the carrier substrate, where the IC structure is an IC structure according to any one of examples 1-31, or the IC structure is included in the IC package according to any one of examples 32-35.

Example 37 provides a computing device according to example 36, where the computing device is a wearable or handheld computing device.

Example 38 provides a computing device according to examples 36 or 37, where the computing device further includes one or more communication chips.

Example 39 provides a computing device according to any one of examples 36-38, where the computing device further includes an antenna.

Example 40 provides a computing device according to any one of examples 36-39, where the carrier substrate is a motherboard.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a stack of two or more nanoribbons, wherein the stack comprises a first nanoribbon and a second nanoribbon;
a first portion of a gate electrode material at least partially around the first nanoribbon;
a second portion of the gate electrode material at least partially around the second nanoribbon;
an insulator material between the first portion and the second portion;
a first contact structure coupled with the first portion; and
a second contact structure coupled with the second portion.

2. The IC structure of claim 1, further comprising:
a first region of a doped semiconductor material in the stack, coplanar with the first nanoribbon, and coupled with the first nanoribbon;
a second region of the doped semiconductor material in the stack, over the first region, coplanar with the second nanoribbon, and coupled with the second nanoribbon; and
the insulator material between the first region and the second region.

3. The IC structure of claim 2, further comprising:
a third region of the doped semiconductor material in the stack, coplanar with the first nanoribbon, and coupled with the first nanoribbon;
a fourth region of the doped semiconductor material in the stack, over the third region, coplanar with the second nanoribbon, and coupled with the second nanoribbon; and
the insulator material between the third region and the fourth region.

4. The IC structure of one of the previous claims, wherein the stack comprises a third nanoribbon, and wherein the IC structure further comprises:
a third portion of the gate electrode material at least partially around the third nanoribbon;
the insulator material between the second portion and the third portion; and
a third gate contact structure coupled with the third portion.

5. The IC structure of one of the previous claims, wherein:
the stack comprises a third nanoribbon, and
the second portion is at least partially around the third nanoribbon.

6. The IC structure of claim 4 or 5, wherein the stack comprises a fourth nanoribbon, and wherein the IC structure further comprises:
a fourth portion of the gate electrode material at least partially around the fourth nanoribbon;
the insulator material between the third portion and the fourth portion; and
a fourth gate contact structure coupled with the fourth portion.

7. The IC structure of claim 4, 5 or 6, wherein:
the stack comprises a fourth nanoribbon between the first nanoribbon and the second nanoribbon, and
the first portion is at least partially around the fourth nanoribbon.

8. The IC structure of one of the previous claims, wherein:
the first contact structure is coplanar with the second nanoribbon.

9. The IC structure of one of the previous claims, wherein:
the first contact structure and the second contact structure are on either side of the stack.

10. The IC structure of one of the previous claims, wherein:
a first transistor has a first channel region in the first nanoribbon, and
a second transistor has a second channel region in the second nanoribbon.

11. The IC structure of one of the previous claims, wherein the stack is a first stack, the two or more nanoribbons are two or more first nanoribbons, and wherein the IC structure further comprises:
a second stack of two or more second nanoribbons, wherein the second stack is adjacent to the first stack, the second stack comprises a third nanoribbon and a fourth nanoribbon; and
a conductive interconnect between the first nanoribbon with the third nanoribbon.

12. The IC structure of claim 11, wherein:
the conductive interconnect is coplanar with and between the first stack and the second stack.

13. The IC structure of claim 11 or 12, wherein:
the first two or more nanoribbons comprise an N-type semiconductor material, and
the second two or more nanoribbons comprise a P-type semiconductor material.

14. The IC structure of one of the previous claims, wherein:
the first nanoribbon comprises an N-type semiconductor material,
the second nanoribbon comprises a P-type semiconductor material, and wherein the IC structure further comprises:
a hybrid bonding interface between the first nanoribbon and the second nanoribbon.

15. The IC structure of one of the previous claims, wherein:
the first nanoribbon comprises an N-type semiconductor material,
the second nanoribbon comprises a P-type semiconductor material,
the second nanoribbon is stacked over the first nanoribbon,
a first conductive via is coupled with the first contact structure,
a second conductive via is coupled with the second contact structure, and
the first conductive via tapers in an opposite direction relative to the second conductive via.
